# EUROPEAN PATENT APPLICATION

(11) **EP 4 395 492 A1**
(43) Date of publication of application: **03.07.2024**
(21) Application number: 23214070.7
(22) Date of filing: 04.12.2023
(51) Int. Cl.: H10B 41/27, H10B 43/40, H10B 43/50

(54) **NONVOLATILE MEMORY DEVICE**

(30) Priority: 27.12.2022 KR 20220186038
(71) Applicant: Samsung Electronics Co., Ltd., Suwon-si, Gyeonggi-do 16677 (KR)
(72) Inventor: CHUN, Sanghun, 16677 Suwon-si (KR); JANG, Sehee, 16677 Suwon-si (KR); HAN, Jeehoon, 16677 Suwon-si (KR)
(74) Representative: Marks & Clerk LLP

(57) **Abstract**

A nonvolatile memory device includes a peripheral circuit structure including a peripheral circuit and a first insulating structure covering the peripheral circuit and a cell array structure bonded to the peripheral circuit structure and including a cell region and a connection region, wherein the cell array structure includes a common source line layer, a buffer insulating layer on the common source line layer, a plurality of contact stop layers buried in the buffer insulating layer, a cell stack which includes a plurality of gate electrodes and a plurality of insulating layers alternately stacked on the buffer insulating layer, a plurality of cell channel structures extending to the common source line layer by passing through the cell stack, a plurality of contact structures each connected to one or more of the plurality of gate electrodes, and a second insulating structure covering the cell stack.

## Description

### BACKGROUND

The inventive concepts relate to nonvolatile memory devices. Additionally, the inventive concepts relate to three-dimensional nonvolatile memory devices.

Consumers demand nonvolatile memory devices having high performance, a small size, and a cheap price. Therefore, to achieve a highly integrated nonvolatile memory device, a three-dimensional nonvolatile memory device in which a plurality of memory cells are disposed in a vertical direction is proposed.

### SUMMARY

The inventive concepts provide nonvolatile memory devices having operation reliability.

According to some aspects of the inventive concepts, there is provided a nonvolatile memory device including a peripheral circuit structure including a peripheral circuit and a first insulating structure covering the peripheral circuit and a cell array structure bonded to the peripheral circuit structure and including a cell region and a connection region, wherein the cell array structure includes a common source line layer, a buffer insulating layer on the common source line layer, a plurality of contact stop layers separated from the common source line layer and buried in the buffer insulating layer, a cell stack which includes a plurality of gate electrodes and a plurality of insulating layers alternately stacked on the buffer insulating layer, and in which the plurality of gate electrodes have a staircase shape in the connection region, a plurality of cell channel structures extending to the common source line layer by passing through the cell stack and the buffer insulating layer in the cell region, a plurality of contact structures respectively in contact with the plurality of contact stop layers by passing through the cell stack in the connection region, and each connected to one or more of the plurality of gate electrodes, and a second insulating structure in contact with the first insulating structure while covering the cell stack.

According to aspects of the inventive concepts, there is provided a nonvolatile memory device includes a peripheral circuit structure including a peripheral circuit and a first insulating structure covering the peripheral circuit and a cell array structure bonded to the peripheral circuit structure and including a cell region and a connection region, wherein the cell array structure includes a common source line layer, a buffer insulating layer on the common source line layer, a plurality of contact stop layers buried in the buffer insulating layer, a cell stack which includes a plurality of gate electrodes and a plurality of insulating layers alternately stacked on the buffer insulating layer, a plurality of cell channel structures extending to the common source line layer by passing through the cell stack, a plurality of contact structures each connected to one or more of the plurality of gate electrodes, and a second insulating structure covering the cell stack.

According to some aspects of the inventive concepts, there is provided a nonvolatile memory device including a peripheral circuit structure including a substrate, a peripheral circuit on the substrate, a first interconnect structure electrically connected to the peripheral circuit, a plurality of first bonding pads electrically connected to the first interconnect structure, and a first insulating structure surrounding the peripheral circuit, the first interconnect structure, and the plurality of first bonding pads on the substrate, and a second structure including a common source line layer, a buffer insulating layer on the common source line layer, a base insulating layer on the buffer insulating layer, a cell stack which includes a plurality of gate electrodes and a plurality of insulating layers alternately stacked on the buffer insulating layer, and in which the plurality of gate electrodes have a staircase shape in a connection region, a plurality of cell channel structures extending to the common source line layer by passing through the cell stack, the base insulating layer, and the buffer insulating layer in a cell region, a plurality of contact structures passing through the cell stack and the base insulating layer in the connection region, and each connected to one or more of the plurality of gate electrodes and including a contact stop portion separated from the common source line layer and buried in the buffer insulating layer, a second interconnect structure electrically connected to the plurality of cell channel structures and the plurality of contact structures, a plurality of second bonding pads electrically connected to the second interconnect structure, and a second insulating structure surrounding the cell stack, the second interconnect structure, and the plurality of second bonding pads on the common source line layer, wherein the second insulating structure is in contact with the first insulating structure, the plurality of second bonding pads are bonded to the peripheral circuit structure to correspond to the plurality of first bonding pads, and the cell region and the connection region are included.

At least some of the above and other features of the invention are set out in the claims.

### BRIEF DESCRIPTION OF THE DRAWINGS

Example embodiments of the inventive concepts will be more clearly understood from the following detailed description taken in conjunction with the accompanying drawings in which:
FIG. 1 is a block diagram of a nonvolatile memory device according to some example embodiments;
FIG. 2 is a schematic perspective view of a nonvolatile memory device according to some example embodiments;
FIG. 3 is an equivalent circuit diagram of a memory cell array in a nonvolatile memory device, according to some example embodiments;
FIG. 4 is a schematic layout of a cell array structure CS included in a nonvolatile memory device according to some example embodiments;
FIGS. 5A and 5B are cross-sectional views of a nonvolatile memory device according to some example embodiments;
FIGS. 6A to 6Q are cross-sectional views illustrating a method of manufacturing a nonvolatile memory device, according to some example embodiments;
FIGS. 7A and 7B are cross-sectional views of a nonvolatile memory device according to some example embodiments;
FIGS. 8A and 8B are cross-sectional views of a nonvolatile memory device according to some example embodiments;
FIG. 9 is a cross-sectional view of a nonvolatile memory device having a cell-to-cell (C2C) structure, according to some example embodiments;
FIG. 10 is a cross-sectional view of a nonvolatile memory device having a C2C structure, according to some example embodiments;
FIG. 11 is a block diagram schematically illustrating a memory system including a nonvolatile memory device, according to some example embodiments;
FIG. 12 is a perspective view schematically illustrating a memory system including a nonvolatile memory device, according to some example embodiments; and
FIG. 13 is a cross-sectional view schematically illustrating a semiconductor package according to some example embodiments.

### DETAILED DESCRIPTION

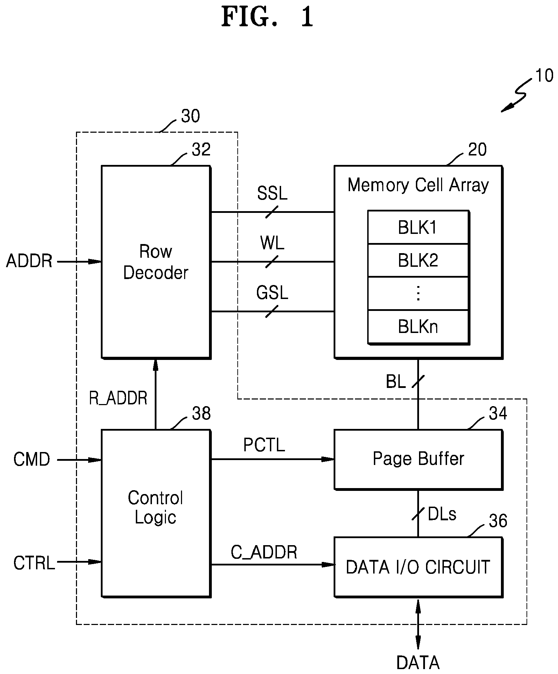

FIG. 1 is a block diagram of a nonvolatile memory device 10 according to some example embodiments.

Referring to FIG. 1, the nonvolatile memory device 10 may include a memory cell array 20 and a peripheral circuit 30. The memory cell array 20 may include a plurality of memory cell blocks BLK1, BLK2, ..., and BLKn. Each of the plurality of memory cell blocks BLK1, BLK2, ..., and BLKn may include a plurality of memory cells. The plurality of memory cell blocks BLK1, BLK2, ..., and BLKn may be connected to the peripheral circuit 30 through bit lines BL, word lines WL, string select lines SSL, and ground select lines GSL.

The peripheral circuit 30 may include a row decoder 32, a page buffer 34, a data input-output (I/O) circuit 36, and a control logic 38. In some example embodiments, the peripheral circuit 30 may further include an input-output interface, a column logic, a voltage generator, a pre-decoder, a temperature sensor, a command decoder, an address decoder, an amplification circuit, and/or the like.

The memory cell array 20 may be connected to the page buffer 34 through the bit lines BL and connected to the row decoder 32 through the word lines WL, the string select lines SSL, and the ground select lines GSL. In the memory cell array 20, each of the plurality of memory cells included in each of the plurality of memory cell blocks BLK1, BLK2, ..., and BLKn may be a flash memory cell. The memory cell array 20 may include a three-dimensional memory cell array. The three-dimensional memory cell array may include a plurality of NAND strings extending in a vertical direction, and each of the plurality of NAND strings may include a plurality of memory cells connected to a plurality of word lines WL vertically stacked on a substrate.

The peripheral circuit 30 may receive an address ADDR, a command CMD, and a control signal CTRL from the outside of the nonvolatile memory device 10 and transmit and receive data DATA to and from a device outside the nonvolatile memory device 10.

The row decoder 32 may select at least one of the plurality of memory cell blocks BLK1, BLK2, ..., and BLKn in response to the address ADDR from the outside and select a word line WL, a string select line SSL, and a ground select line GSL of the selected memory cell block. The row decoder 32 may provide, to the word line WL of the selected memory cell block, a voltage for performing a memory operation.

The page buffer 34 may be connected to the memory cell array 20 through the bit lines BL. The page buffer 34 may operate as a write driver during a program operation to apply, to the bit lines BL, a voltage according to the data DATA to be stored in the memory cell array 20, and may operate as a sensing amplifier during a read operation to sense the data DATA stored in the memory cell array 20. The page buffer 34 may operate in response to a control signal PCTL provided from the control logic 38.

The data input-output circuit 36 may be connected to the page buffer 34 through data lines DLs. During a program operation, the data input-output circuit 36 may receive the data DATA from a memory controller (not shown) and provide the data DATA to the page buffer 34 as program data based on a column address C_ADDR provided from the control logic 38. During a read operation, the data input-output circuit 36 may provide the data DATA stored in the page buffer 34 to the memory controller as read data based on the column address C_ADDR provided from the control logic 38.

The data input-output circuit 36 may provide an input address or instruction to the control logic 38 or the row decoder 32. The peripheral circuit 30 may further include an electrostatic discharge (ESD) circuit and a pull-up/pull-down driver.

The control logic 38 may receive the command CMD and the control signal CTRL from the memory controller. The control logic 38 may provide a row address R_ADDR to the row decoder 32 and provide the column address C_ADDR to the data input-output circuit 36. The control logic 38 may generate various kinds of internal control signals to be used inside the nonvolatile memory device 10, in response to the control signal CTRL. For example, the control logic 38 may adjust voltage levels to be provided to the word lines WL and the bit lines BL during a memory operation, such as a program operation or an erase operation.

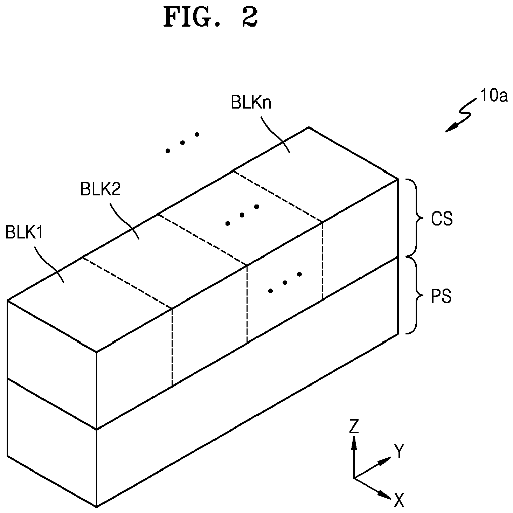

FIG. 2 is a schematic perspective view of the nonvolatile memory device 10a according to some example embodiments.

Referring to FIG. 2, the nonvolatile memory device 10a may include a cell array structure CS and a peripheral circuit structure PS overlapping each other in a vertical direction (a Z direction). The cell array structure CS may include the memory cell array 20 described with reference to FIG. 1. The peripheral circuit structure PS may include the peripheral circuit 30 described with reference to FIG. 1.

The cell array structure CS may include the plurality of memory cell blocks BLK1, BLK2, ..., and BLKn. Each of the plurality of memory cell blocks BLK1, BLK2, ..., and BLKn may include three-dimensionally arranged memory cells.

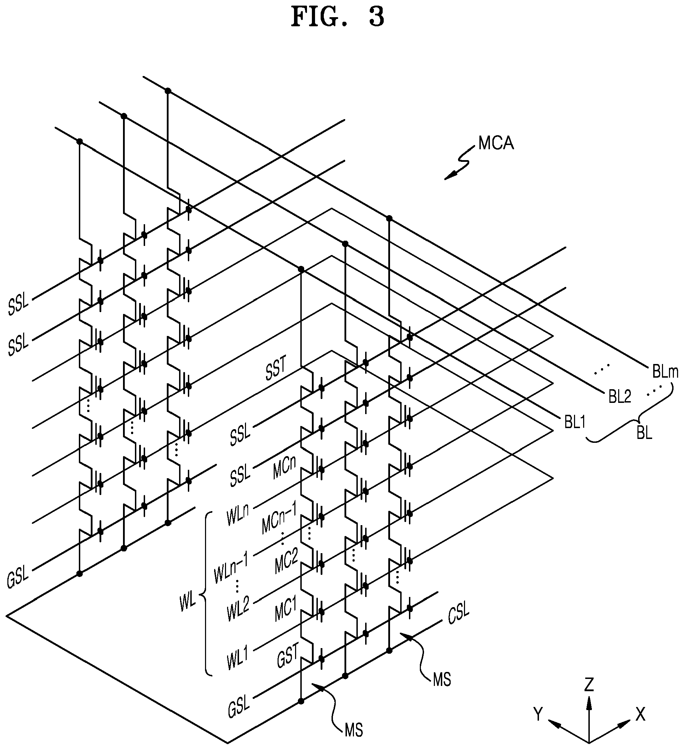

FIG. 3 is an equivalent circuit diagram of a memory cell array MCA in a nonvolatile memory device, according to some example embodiments.

Referring to FIG. 3, the memory cell array MCA may include a plurality of memory cell strings MS. Each of the plurality of memory cell strings MS may extend in the vertical direction (the Z direction). The memory cell array MCA may include a plurality of word lines WL (WL1, WL2, ..., WLn-1, and WLn), a plurality of bit lines BL (BL1, BL2, ..., and BLm), at least one string select line SSL, at least one ground select line GSL, and a common source line CSL. Each of the plurality of word lines WL (WL1, WL2, ..., WLn-1, and WLn) may extend in a first horizontal direction (an X direction), and each of the plurality of bit lines BL (BL1, BL2, ..., and BLm) may extend in a second horizontal direction (a Y direction) that is perpendicular to the first horizontal direction (an X direction). Each of the at least one string select line SSL and the at least one ground select line GSL may extend in the same direction as the plurality of word lines WL (WL1, WL2, ..., WLn-1, and WLn), for example, in the first horizontal direction (the X direction). The plurality of memory cell strings MS may be formed between the plurality of bit lines BL (BL1, BL2, ..., and BLm) and the common source line CSL. Although FIG. 3 shows that each of the plurality of memory cell strings MS includes two string select lines SSL, the technical ideas of the inventive concepts are not limited thereto. For example, each of the plurality of memory cell strings MS may include one string select line SSL.

Each of the plurality of memory cell strings MS may include a string select transistor SST, a ground select transistor GST, and a plurality of memory cell transistors MC1, MC2, ..., MCn-1, and MCn. A drain region of the string select transistor SST may be connected to a bit line BL (BL1, BL2, ..., or BLm), and a source region of the ground select transistor GST may be connected to the common source line CSL. The common source line CSL may be a region to which source regions of a plurality of ground select transistors GST are commonly connected.

The string select transistor SST may be connected to a string select line SSL, and the ground select transistor GST may be connected to a ground select line GSL. The plurality of memory cell transistors MC1, MC2, ..., MCn-1, and MCn may be connected to the plurality of word lines WL (WL1, WL2, ..., WLn-1, and WLn), respectively.

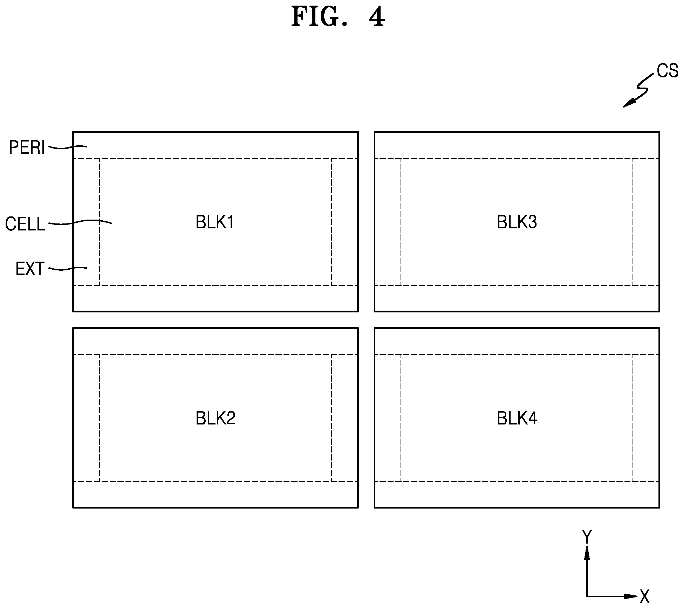

FIG. 4 is a schematic layout of a cell array structure CS included in a nonvolatile memory device, according to some example embodiments.

Referring to FIG. 4, the cell array structure CS may include a plurality of memory cell blocks BLK1, BLK2, BLK3, and BLK4. The plurality of memory cell blocks BLK1, BLK2, BLK3, and BLK4 may be arranged in rows and columns in the first horizontal direction (the X direction) and the second horizontal direction (the Y direction). The first horizontal direction (the X direction) may be an extending direction of each of the plurality of word lines WL (WL1, WL2, ..., WLn-1, and WLn) shown in FIG. 3, and the second horizontal direction (the Y direction) may be an extending direction of each of the plurality of bit lines BL (BL1, BL2, ..., and BLm) shown in FIG. 3. Each of the plurality of memory cell blocks BLK1, BLK2, BLK3, and BLK4 may include a plurality of memory cells.

Each of the plurality of memory cell blocks BLK1, BLK2, BLK3, and BLK4 may include a cell region CELL and a connection region EXT. In some example embodiments, each of the plurality of memory cell blocks BLK1, BLK2, BLK3, and BLK4 may include one cell region CELL and a pair of connection regions EXT, with a connection region EXT at each side of the one cell region CELL. The pair of connection regions EXT may extend in the second horizontal direction (the Y direction) at both sides of the one cell region CELL in the first horizontal direction (the X direction). In some example embodiments, each of the plurality of memory cell blocks BLK1, BLK2, BLK3, and BLK4 may include one cell region CELL and one connection region EXT at one side of the one cell region CELL. In some example embodiments, each of the plurality of memory cell blocks BLK1, BLK2, BLK3, and BLK4 may include one cell region CELL and two pairs of connection regions EXT, with a connection region EXT at each side of the one cell region CELL in the first horizontal direction (the X direction) and at each side of the one cell region CELL in the second horizontal direction (the Y direction).

In some example embodiments, each of the plurality of memory cell blocks BLK1, BLK2, BLK3, and BLK4 may further include a cell peripheral circuit region PERI. The cell peripheral circuit region PERI may be at one side or both sides of the cell region CELL in the second horizontal direction (the Y direction). For example, in the cell peripheral circuit region PERI, components configured to connect the peripheral circuit structure PS described with reference to FIG. 2 to the cell region CELL and/or the connection region EXT may be arranged. As another example, the cell peripheral circuit region PERI may include at least a portion of the peripheral circuit 30 described with reference to FIG. 1.

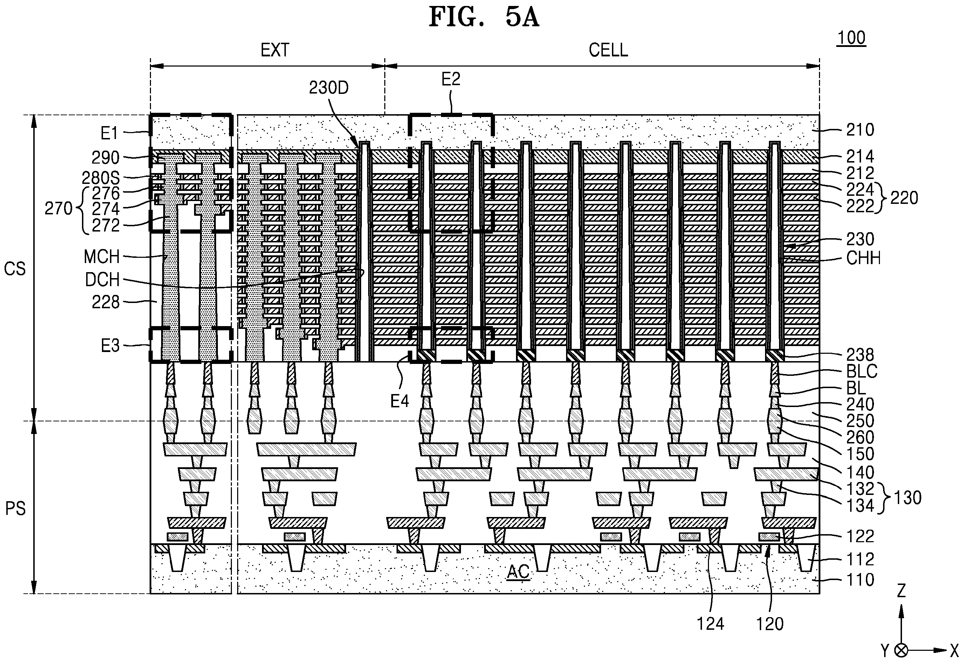

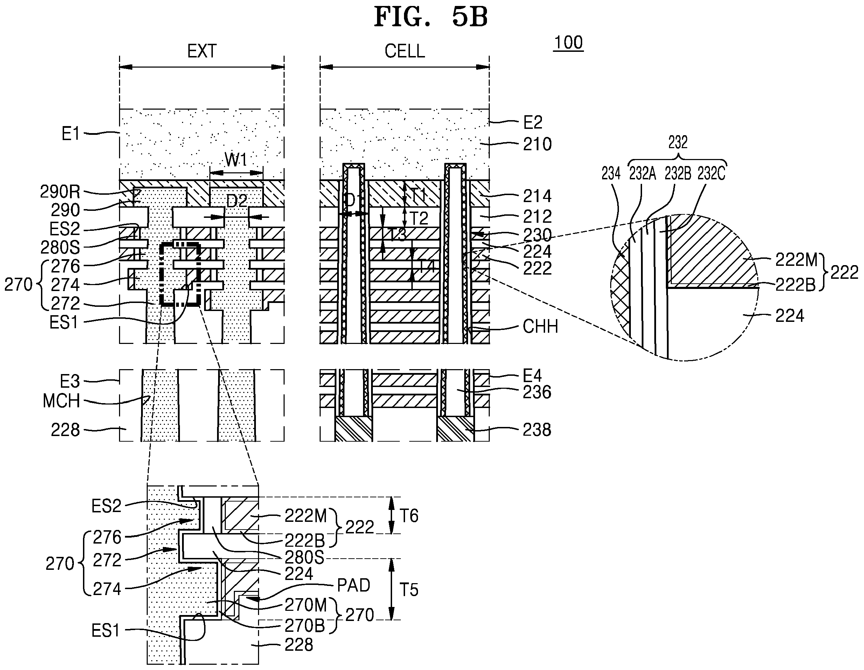

FIGS. 5A and 5B are cross-sectional views of a nonvolatile memory device 100 according to some example embodiments. Particularly, FIG. 5B shows magnified views of portions E1, E2, E3, and E4 of FIG. 5A.

Referring to FIGS. 5A and 5B, the nonvolatile memory device 100 may include a peripheral circuit structure PS and a cell array structure CS bonded to each other in the vertical direction (the Z direction). The peripheral circuit structure PS and the cell array structure CS may be called a first structure and a second structure, respectively. The peripheral circuit structure PS may include the peripheral circuit 30 described with reference to FIG. 1, and the cell array structure CS may include the memory cell array 20 described with reference to FIG. 1. The cell array structure CS may include three-dimensionally arranged memory cells. The cell array structure CS may include a cell region CELL and a connection region EXT.

The cell array structure CS may further include the cell peripheral circuit region PERI shown in FIG. 4. In the cell peripheral circuit region PERI, components configured to connect the peripheral circuit structure PS to the cell region CELL and/or the connection region EXT, such as a common source line contact plug electrically connecting a common source line layer 210 to the peripheral circuit structure PS and an input-output contact plug electrically connecting an input-output pad to the peripheral circuit structure PS, may be arranged.

The peripheral circuit structure PS may include a substrate 110, a peripheral circuit 120 on the substrate 110, a first interconnect structure 130 electrically connected to the peripheral circuit 120, a first bonding pad 150 electrically connected to the first interconnect structure 130, and a first insulating structure 140 on the substrate 110 and the peripheral circuit 120.

The substrate 110 may include a semiconductor material, for example, a Group IV semiconductor material, a Group III-V semiconductor material, a Group II-VI semiconductor material, or a Group II-VI oxide semiconductor material. The Group IV semiconductor material may include, for example, silicon (Si), germanium (Ge), and/or SiGe. The Group III-V semiconductor material may include, for example, gallium arsenide (GaAs), indium phosphide (InP), gallium phosphide (GaP), indium arsenide (InAs), indium antimony (InSb), and/or indium gallium arsenide (InGaAs). The Group II-VI semiconductor material may include, for example, zinc telluride (ZnTe) and/or cadmium sulfide (CdS). The substrate 110 may be a bulk wafer or an epitaxial layer. The substrate 110 may be provided as a bulk wafer or an epitaxial layer. In some example embodiments, the substrate 110 may include a silicon-on-insulator (SOI) substrate or a germanium-on-insulator (GeOI) substrate. The substrate 110 may have an active region AC defined by a device isolation layer 112, and a plurality of peripheral circuits 120 may be formed on the active region AC. Each of the plurality of peripheral circuits 120 may include a peripheral circuit gate 122 and a source/drain region 124 in a portion of the substrate 110 at both sides of the peripheral circuit gate 122.

The first interconnect structure 130 may include a plurality of peripheral circuit wiring layers 132 and a plurality of peripheral circuit contacts 134. The first interconnect structure 130 may include a conductive material, such as copper (Cu), aluminum (Al), tungsten (W), silver (Ag), gold (Au), or a combination thereof. The first bonding pad 150 may be on the first interconnect structure 130 and electrically connected to the peripheral circuit 120 and/or the substrate 110 via the first interconnect structure 130. The first insulating structure 140 may surround the peripheral circuit 120, the first interconnect structure 130, and the first bonding pad 150 on the substrate 110.

The first bonding pad 150 may have an upper surface coplanar with an upper surface of the first insulating structure 140.

In some example embodiments, the first insulating structure 140 may include an insulating material, such as silicon oxide, silicon nitride, a low-k material, or a combination thereof. The low-k material is a material having a lower dielectric constant than silicon oxide and may include, for example, phosphosilicate glass (PSG), borophosphosilicate glass (BPSG), fluorosilicate glass (FSG), organosilicate glass (OSG), spin-on-glass (SOG), spin-on-polymer, or a combination thereof. In some example embodiments, the first insulating structure 140 may include an ultra low k (ULK) layer having an ultra low dielectric constant K of about or exactly 2.2 to about or exactly 2.4. The ULK layer may include silicon oxycarbide (SiOC) and/or silicon carbon hydroxide (SiCOH). The first bonding pad 150 may include a conductive material, such as Cu, Au, Ag, Al, W, titanium (Ti), tantalum (Ta), or a combination thereof.

The cell array structure CS may include the common source line layer 210, a cell stack 220 beneath the common source line layer 210, a second interconnect structure 240 electrically connected to the cell stack 220, a second bonding pad 260 electrically connected to the second interconnect structure 240, and a second insulating structure 250 surrounding the second interconnect structure 240 and the second bonding pad 260 while covering the cell stack 220 under the cell stack 220. The second bonding pad 260 may have a lower surface coplanar with a lower surface of the second insulating structure 250.

Although FIG. 5A shows that the second interconnect structure 240 includes a plurality of contacts, this is only illustrative, and the second interconnect structure 240 is not limited thereto. For example, like the first interconnect structure 130 including the plurality of peripheral circuit wiring layers 132 and the plurality of peripheral circuit contacts 134, the second interconnect structure 240 may include a plurality of wiring layers in addition to a plurality of contacts. The second interconnect structure 240 and the second insulating structure 250 may include the same or similar materials as or to those of the first interconnect structure 130 and the first insulating structure 140, respectively.

By making the second insulating structure 250 be in contact with the first insulating structure 140 and making the second bonding pad 260 be in contact with the first bonding pad 150 corresponding thereto, the cell array structure CS may be bonded to the peripheral circuit structure PS. For example, the peripheral circuit structure PS and the cell array structure CS may be bonded to each other by metal-oxide hybrid bonding, and accordingly, the second interconnect structure 240 included in the cell array structure CS may be electrically connected to the peripheral circuit 120 included in the peripheral circuit structure PS.

The cell stack 220 may include a plurality of gate electrodes 222 and a plurality of insulating layers 224 alternately disposed on the common source line layer 210. The plurality of gate electrodes 222 may include W, Cu, Ag, Au, Al, or a combination thereof or include a conductive material which is not limited thereto. The plurality of insulating layers 224 may include an insulating material, such as silicon oxide, a low-k material, or a combination thereof. A buffer insulating layer 214 and a base insulating layer 212 may be between the common source line layer 210 and the cell stack 220. For example, the buffer insulating layer 214 may be between the common source line layer 210 and the base insulating layer 212, and the base insulating layer 212 may be between the buffer insulating layer 214 and the top insulating layer 224 in the cell stack 220.

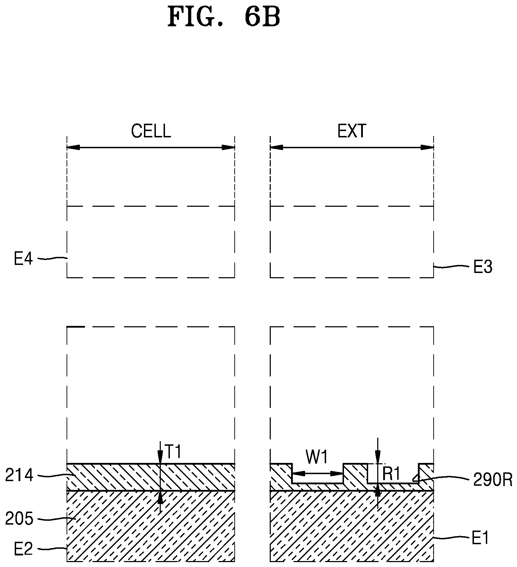

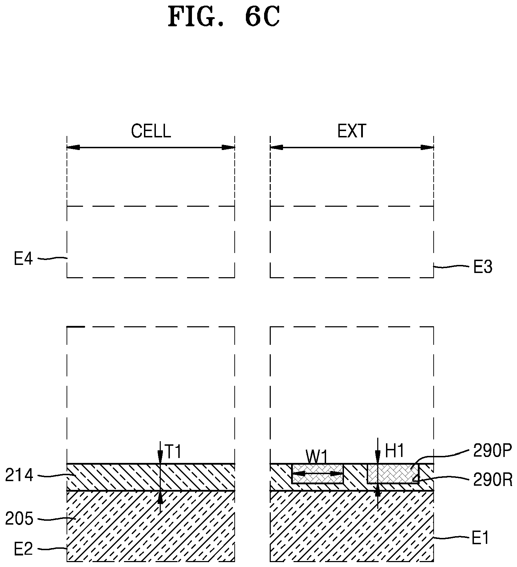

The buffer insulating layer 214 may have a first thickness T1, the base insulating layer 212 may have a second thickness T2, a gate electrode 222 may have a third thickness T3, and an insulating layer 224 may have a fourth thickness T4. The first thickness T1 may be greater than or equal to the second thickness T2. For example, the first thickness T1 may be about or exactly 75 nm to about or exactly 120 nm, and the second thickness T2 may be about or exactly 75 nm to about or exactly 100 nm. The third thickness T3 and the fourth thickness T4 may be less than the first thickness T1 and the second thickness T2, respectively. The third thickness T3 may be greater than or equal to the fourth thickness T4. For example, the third thickness T3 may be about or exactly 10 nm to about or exactly 20 nm, and the fourth thickness T4 may be about or exactly 10 nm to about or exactly 15 nm. The third thickness T3 and the fourth thickness T4 may be less than a first height H1 (see FIG. 6C) and a first depth R1 (see FIG. 6B), respectively.

In the cell region CELL, a plurality of cell channel structures 230 extending in the vertical direction by passing through the cell stack 220 including the plurality of gate electrodes 222 and the plurality of insulating layers 224 may be arranged. Along each of the plurality of cell channel structures 230, a memory cell string MS (see FIG. 3) including a plurality of memory cells may be formed.

The common source line layer 210 may function as a source region configured to supply a current to memory cells formed in the cell array structure CS. The common source line layer 210 may correspond to the common source line CSL shown in FIG. 3. The common source line layer 210 may include a semiconductor material, for example, a Group IV semiconductor material, a Group III-V semiconductor material, or a Group II-VI semiconductor material. For example, the common source line layer 210 may include at least one of Si, Ge, SiGe, GaAs, indium gallium arsenide (InGaAs), aluminum gallium arsenide (AlGaAs), and a mixture thereof In addition, the common source line layer 210 may include a semiconductor doped with n-type impurities. In addition, the common source line layer 210 may have a crystal structure including at least one selected from among a monocrystalline structure, an amorphous structure, and a polycrystalline structure. In some example embodiments, the common source line layer 210 may include a semiconductor material without containing carbon. For example, the common source line layer 210 may include polysilicon. In some example embodiments, the common source line layer 210 may include polysilicon without containing carbon. In some example embodiments, the common source line layer 210 may include polysilicon doped with n-type impurities. The common source line layer 210 may be arranged such that a cell channel structure 230 is in contact with the common source line layer 210 by passing through the plurality of gate electrodes 222 and the plurality of insulating layers 224. Although FIG. 5A shows that the common source line layer 210 is integrally formed over the cell region CELL and the connection region EXT, this is only illustrative for convenience of drawing, and the common source line layer 210 is not limited thereto. For example, respective portions of the common source line layer 210 in the cell region CELL and the connection region EXT may be separated from each other. As another example, a plurality of common source line layers 210 in the cell region CELL may be separated from each other.

In some example embodiments, the plurality of gate electrodes 222 may correspond to the at least one ground select line GSL, the plurality of word lines WL (WL1, WL2, ..., WLn-1, and WLn), and the at least one string select line SSL included in the memory cell string MS shown in FIG. 3. For example, a gate electrode 222 closest to the common source line layer 210 may function as a ground select line GSL, two gate electrodes 222 farthest from the common source line layer 210 may function as string select lines SSL, and the other gate electrodes 222 may function as the plurality of word lines WL. Accordingly, a memory cell string MS in which a ground select transistor GST, two string select transistors SST, and memory cell transistors MC1, MC2, ..., MCn-1, and MCn therebetween are connected in series may be provided.

In some example embodiments, at least one gate electrode 222 may function as a dummy word line. For example, at least one gate electrode 222 functioning as an additional dummy word line may be between the gate electrode 222 functioning as the ground select line GSL and the common source line layer 210, at least one gate electrode 222 functioning as an additional dummy word line may be between the gate electrode 222 functioning as the ground select line GSL and a gate electrode 222 functioning as a word line WL, or at least one gate electrode 222 functioning as an additional dummy word line may be between a gate electrode 222 functioning as a word line WL and a gate electrode 222 functioning as a string select line SSL.

In the cell region CELL, the plurality of cell channel structures 230 may extend in the vertical direction (the Z direction) to the common source line layer 210 by passing through the plurality of gate electrodes 222 and the plurality of insulating layers 224. The plurality of cell channel structures 230 may be connected to the common source line layer 210 by passing through the cell stack 220 including the plurality of gate electrodes 222 and the plurality of insulating layers 224, the base insulating layer 212, and the buffer insulating layer 214. In some example embodiments, the plurality of cell channel structures 230 may extend to the inside of the common source line layer 210 by passing through the cell stack 220 including the plurality of gate electrodes 222 and the plurality of insulating layers 224, the base insulating layer 212, and the buffer insulating layer 214.

The plurality of cell channel structures 230 may be separated by a certain interval from each other in the first horizontal direction (the X direction), the second horizontal direction (the Y direction), and a third horizontal direction (for example, a diagonal direction with respect to the first horizontal direction (the X direction) and the second horizontal direction (the Y direction)). The plurality of cell channel structures 230 may be arranged in a zigzag shape or a staggered shape. Each of the plurality of cell channel structures 230 may include a conductive plug 238. The conductive plug 238 may be at one end of each of the plurality of cell channel structures 230, which is opposite to the common source line layer 210.

The plurality of cell channel structures 230 may be in a plurality of channel holes CHH in the cell region CELL, respectively. The plurality of channel holes CHH may extend to the inside of the common source line layer 210 by passing through the cell stack 220 including the plurality of gate electrodes 222 and the plurality of insulating layers 224, the base insulating layer 212, and the buffer insulating layer 214.

Each of the plurality of cell channel structures 230 may include a gate insulating layer 232, a channel layer 234, a buried insulating layer 236, and a conductive plug 238. The gate insulating layer 232 and the channel layer 234 may be sequentially on the inner wall of a channel hole CHH. For example, the gate insulating layer 232 may conformally cover the inner wall of a portion of the channel hole CHH passing through the cell stack 220 including the plurality of gate electrodes 222 and the plurality of insulating layers 224, the base insulating layer 212, and the buffer insulating layer 214, and the channel layer 234 may conformally cover the inner wall and the ceiling surface of the channel hole CHH. The channel layer 234 may cover the inner wall and the ceiling surface of the channel hole CHH extending to the inside of the common source line layer 210 to be in contact with the common source line layer 210. The gate insulating layer 232 may not extend to the inside of the common source line layer 210. For example, the top of the gate insulating layer 232 may be in contact with a lower surface of the common source line layer 210. The channel layer 234 may extend to the inside of the common source line layer 210 along the inner wall of the channel hole CHH extending to the inside of the common source line layer 210. For example, the top of the channel layer 234 may be at a higher vertical level than the lower surface of the common source line layer 210. Herein, the lower surface of the common source line layer 210 indicates the lower surface of the common source line layer 210 except for the inner wall and the ceiling surface of a portion of the channel hole CHH extending to the inside of the common source line layer 210.

The buried insulating layer 236 filling a remaining space of the channel hole CHH may be on the channel layer 234. The conductive plug 238 covering the entrance of the channel hole CHH while being in contact with the channel layer 234 may be beneath the channel hole CHH. In some example embodiments, the buried insulating layer 236 may be omitted, and the channel layer 234 may be formed in a pillar shape filling the remaining space of the channel hole CHH.

The gate electrode 222 may include a metal, such as W, nickel, cobalt, Ta, conductive metal nitride, such as titanium nitride (TiN), tantalum nitride (TaN), or tungsten nitride, metal silicide, such as tungsten silicide, nickel silicide, cobalt silicide, or tantalum silicide, doped polysilicon, or a combination thereof. In some example embodiments, a dielectric liner may be between the gate electrode 222 and the insulating layer 224, and the dielectric liner may include a high-k material, such as aluminum oxide.

The gate insulating layer 232 may have a structure including a tunneling dielectric layer 232A, a charge storage layer 232B, and a blocking dielectric layer 232C sequentially on the outer wall of the channel layer 234. Relative thicknesses of the tunneling dielectric layer 232A, the charge storage layer 232B, and the blocking dielectric layer 232C forming the gate insulating layer 232 are not limited to those shown in FIG. 5B and may be variously modified.

The tunneling dielectric layer 232A may include silicon oxide, hafnium oxide, aluminum oxide, zirconium oxide, tantalum oxide, and/or the like. The charge storage layer 232B is a region in which electrons having passed through the tunneling dielectric layer 232A from the channel layer 234 may be stored, and may include silicon nitride, boron nitride, silicon boron nitride, and/or impurity-doped polysilicon. The blocking dielectric layer 232C may include silicon oxide, silicon nitride, and/or metal oxide having a greater dielectric constant than the silicon oxide. The metal oxide may include hafnium oxide, aluminum oxide, zirconium oxide, tantalum oxide, or a combination thereof.

Bit lines BL may extend in the second horizontal direction (the Y direction) and be separated from each other in the first horizontal direction (the X direction), each bit line BL may be electrically connected to a cell channel structure 230 by a bit line contact BLC. The bit line contact BLC may be connected to the conductive plug 238.

In the connection region EXT, each of the plurality of gate electrodes 222 may constitute a pad portion PAD. In some example embodiments, in the connection region EXT, the plurality of gate electrodes 222 may extend to have a length gradually decreasing in the first horizontal direction (the X direction) away from the common source line layer 210. In some example embodiments, in the connection region EXT, the plurality of gate electrodes 222 may extend to have a length gradually decreasing in the first horizontal direction (the X direction) and the second horizontal direction (the Y direction) away from the common source line layer 210. Pad portions PAD may indicate staircase-shaped portions of the plurality of gate electrodes 222. In some example embodiments, the pad portions PAD may have a staircase shape in the first horizontal direction (the X direction). In some example embodiments, the pad portions PAD may have a staircase shape in each of the first horizontal direction (the X direction) and the second horizontal direction (the Y direction). In some example embodiments, at least some of the portions of the plurality of gate electrodes 222 constituting the pad portions PAD may have a greater thickness than portions of the plurality of gate electrodes 222 in the cell region CELL.

In the connection region EXT and/or the cell region CELL, a dummy channel structure 230D extending in the vertical direction (the Z direction) to the common source line layer 210 by passing through the plurality of gate electrodes 222, the plurality of insulating layers 224, the base insulating layer 212, and the buffer insulating layer 214 may be formed. Although FIG. 5A shows only one dummy channel structure 230D in the connection region EXT, this is only illustrative, and the dummy channel structure 230D is not limited thereto. For example, in the connection region EXT, a plurality of dummy channel structures 230D may be near a plurality of cell contact structures 270, respectively. For example, in the cell region CELL, a plurality of dummy channel structures 230D may be near the plurality of cell channel structures 230, respectively.

The plurality of dummy channel structures 230D may be in a plurality of dummy channel holes DCH in the connection region EXT and/or the cell region CELL. The plurality of dummy channel holes DCH may extend to the inside of the common source line layer 210 by passing through the cell stack 220 including the plurality of gate electrodes 222 and the plurality of insulating layers 224, the base insulating layer 212, and the buffer insulating layer 214. The dummy channel structure 230D may be formed to prevent or reduce leaning, bending, or the like of the gate electrode 222 and ensure or improve the structural stability of the gate electrode 222 in a manufacturing process of the nonvolatile memory device 100. In some example embodiments, the dummy channel structure 230D may have generally the same or similar structure and shape as or to that of the cell channel structure 230. In some example embodiments, the dummy channel structure 230D may have a different structure and shape from that of the cell channel structure 230.

In the connection region EXT, a filling insulating layer 228 surrounding the plurality of cell contact structures 270 while covering the portions of the plurality of gate electrodes 222 constituting the pad portions PAD may be arranged. The second insulating structure 250 may cover the cell stack 220 and the filling insulating layer 228. In some example embodiments, the second insulating structure 250 may include a plurality of insulating layers (not shown), and each of the plurality of insulating layers may cover a bit line contact BLC, a bit line BL, and a second interconnect structure 240.

In the connection region EXT, the plurality of cell contact structures 270 respectively connected to the pad portions PAD of the plurality of gate electrodes 222 by passing through the filling insulating layer 228 may be arranged. A bit line contact BLC and a bit line BL connected to the bit line contact BLC may be beneath each of the plurality of cell contact structures 270, and the bit line BL may be connected to a second interconnect structure 240. The plurality of cell contact structures 270 may extend in the vertical direction (the Z direction) to the buffer insulating layer 214 by passing through the plurality of gate electrodes 222, the plurality of insulating layers 224, and the base insulating layer 212. The plurality of cell contact structures 270 may be separated from the common source line layer 210 without being in contact with the common source line layer 210. Each of the plurality of cell contact structures 270 may pass through a pad portion PAD of a gate electrode 222 electrically connected thereto among the plurality of gate electrodes 222. Vertical heights of the plurality of cell contact structures 270 may be identical to each other.

The buffer insulating layer 214 may have a plurality of buffer recesses 290R. A buffer recess 290R may extend inward from a lower surface of the buffer insulating layer 214 but does not pass through the buffer insulating layer 214, and thus, the buffer recess 290R may be separated from the common source line layer 210. A plurality of contact stop layers 290 may respectively fill the plurality of buffer recesses 290R to be buried in the buffer insulating layer 214. The plurality of contact stop layers 290 may be separated from the common source line layer 210 with portions of the buffer insulating layer 214 therebetween. Lower surfaces of the plurality of contact stop layers 290 may be at the same vertical level as the lower surface of the buffer insulating layer 214, and upper surfaces of the plurality of contact stop layers 290 may be at a lower vertical level than an upper surface of the buffer insulating layer 214. Each of the plurality of contact stop layers 290 or the plurality of buffer recesses 290R may have a first horizontal width W1. For example, the first horizontal width W1 may be about or exactly 150 nm to about or exactly 500 nm. Each of the plurality of buffer recesses 290R may have a first depth R1 (see FIG. 6B), and each of the plurality of contact stop layers 290 may have a first height H1 (see FIG. 6C). The first depth R1 may be substantially the same or the same as the first height H1. The first depth R1 and the first height H1 may be less than the first thickness T1. For example, the first depth R1 and the first height H1 may be about or exactly 20 nm to about or exactly 70 nm.

The plurality of cell contact structures 270 may be in contact with the plurality of contact stop layers 290, respectively. The plurality of cell contact structures 270 may be respectively in contact with the plurality of contact stop layers 290 by passing through the plurality of gate electrodes 222, the plurality of insulating layers 224, and the base insulating layer 212. The plurality of cell contact structures 270 may be separated from the common source line layer 210 with the plurality of contact stop layers 290 therebetween, respectively. For example, each of the plurality of contact stop layers 290 and a portion of the buffer insulating layer 214 may be between each of the plurality of cell contact structures 270 and the common source line layer 210. In some embodiment, a cell contact structure 270 and a contact stop layer 290 connected to each other may be formed together and integrated. When a cell contact structure 270 and a contact stop layer 290 connected to each other may be formed together and integrated, the contact stop layer 290 may be referred to as a contact stop portion of the cell contact structure 270.

Each of the plurality of cell contact structures 270 may include a base contact portion 272 and a pad connection portion 274. A plurality of base contact portions 272 of the plurality of cell contact structures 270 may be in a plurality of contact holes MCH in the connection region EXT, respectively. The plurality of contact holes MCH may pass through the cell stack 220 including the plurality of gate electrodes 222 and the plurality of insulating layers 224 and the base insulating layer 212. A plurality of pad connection portions 274 of the plurality of cell contact structures 270 may be in a plurality of first extended spaces ES1, respectively. The plurality of first extended spaces ES1 may communicate with the plurality of contact holes MCH, respectively. The pad connection portion 274 may surround the perimeter of the base contact portion 272. In some example embodiments, in a top view, the pad connection portion 274 may have a ring shape to surround the perimeter of the base contact portion 272. The pad connection portion 274 of one of the plurality of cell contact structures 270 may protrude from the base contact portion 272 toward a gate electrode 222 electrically connected to the one cell contact structure 270 among the plurality of gate electrodes 222. The plurality of pad connection portions 274 of the plurality of cell contact structures 270 may be in contact with the pad portions PAD of the plurality of gate electrodes 222 to electrically connect the plurality of cell contact structures 270 to the plurality of gate electrodes 222, respectively. The pad portions PAD of the plurality of gate electrodes 222 may be in contact with the plurality of pad connection portions 274 of the plurality of cell contact structures 270 and surround the perimeters of the plurality of pad connection portions 274, respectively.

In some embodiments, each of the plurality of cell contact structures 270 may further include at least one protrusion portion 276. In some example embodiments, a cell contact structure 270 electrically connected to the top gate electrode 222 of the plurality of gate electrodes 222, for example, the gate electrode 222 closest to the common source line layer 210, may not include the protrusion portion 276 and may include only the base contact portion 272 and the pad connection portion 274.

A plurality of protrusion portions 276 of each of the plurality of cell contact structures 270 may be in a plurality of second extended spaces ES2, respectively. The plurality of second extended spaces ES2 may communicate with each of the plurality of contact holes MCH. The at least one protrusion portion 276 may surround the perimeter of the base contact portion 272. In some example embodiments, in a top view, the at least one protrusion portion 276 may have a ring shape to surround the perimeter of the base contact portion 272. The at least one protrusion portion 276 of one of the plurality of cell contact structures 270 may protrude from the base contact portion 272 toward at least one gate electrode 222 electrically isolated from the one cell contact structure 270 among the plurality of gate electrodes 222. An insulating spacer 280S may be between the at least one protrusion portion 276 of one of the plurality of cell contact structures 270 and the at least one gate electrode 222 electrically isolated from the one of the plurality of cell contact structures 270.

The base contact portion 272, the pad connection portion 274, and the protrusion portion 276 of each of the plurality of cell contact structures 270 may be formed together and integrated. A difference between a protruding length of the pad connection portion 274 and a protruding length of the protrusion portion 276 in a horizontal direction from the base contact portion 272 may be substantially the same or the same as a horizontal width of the insulating spacer 280S.

Each of the plurality of cell channel structures 230 or the plurality of channel holes CHH may have a first horizontal diameter D1 in the horizontal direction, and each of the plurality of base contact portions 272 or the plurality of contact holes MCH may have a second horizontal diameter D2 in the horizontal direction. The second horizontal diameter D2 may be less than the first horizontal width W1. At the same vertical level, the second horizontal diameter D2 may be greater than or equal to the first horizontal diameter D1. For example, the first horizontal diameter D1 may be about or exactly 80 nm to about or exactly 150 nm, and the second horizontal diameter D2 may be about or exactly 100 nm to about or exactly 150 nm. In some example embodiments, each of the plurality of dummy channel structures 230D and the plurality of dummy channel holes DCH may have the second horizontal diameter D2.

The pad connection portion 274 may have a fifth thickness T5, and the protrusion portion 276 may have a sixth thickness T6. The fifth thickness T5 may be greater than the sixth thickness T6. For example, the fifth thickness T5 may be greater by at least 1.5 times than the sixth thickness T6. In some example embodiments, the sixth thickness T6 may be substantially the same or the same as the third thickness T3. Each of the portions of the plurality of gate electrodes 222 constituting the pad portions PAD may have substantially the same or the same thickness as the fifth thickness T5. That is, the fifth thickness T5 of the pad connection portion 274 may be substantially the same or the same as a thickness of the pad portion PAD in contact with the pad connection portion 274, and the sixth thickness T6 of the protrusion portion 276 may be substantially the same or the same as the third thickness T3 of each of the plurality of gate electrodes 222 except for the pad portions PAD.

The gate electrode 222 may include a main electrode layer 222M and a barrier electrode layer 222B covering the surface of the main electrode layer 222M. The cell contact structure 270 may include a main contact layer 270M and a barrier contact layer 270B covering the surface of the main contact layer 270M. For example, the main electrode layer 222M and the main contact layer 270M may include W, Cu, Ag, Au, Al, or a combination thereof or include a conductive material, though not limited thereto. For example, the barrier electrode layer 222B and the barrier contact layer 270B may include Ti, TiN, Ta, TaN, or a combination thereof.

For example, the barrier electrode layer 222B may be in contact with the insulating layer 224, the filling insulating layer 228, the gate insulating layer 232, the barrier contact layer 270B, and the insulating spacer 280S, and the main electrode layer 222M may be separated from the insulating layer 224, the filling insulating layer 228, the gate insulating layer 232, the barrier contact layer 270B, and the insulating spacer 280S with the barrier electrode layer 222B therebetween. For example, the barrier contact layer 270B may be in contact with the insulating layer 224, the filling insulating layer 228, the barrier electrode layer 222B, and the insulating spacer 280S, and the main contact layer 270M may be separated from the insulating layer 224, the filling insulating layer 228, the barrier electrode layer 222B, and the insulating spacer 280S with the barrier contact layer 270B therebetween. The barrier contact layer 270B and the barrier electrode layer 222B may be between the main contact layer 270M of the pad connection portion 274 and the main electrode layer 222M of the pad portion PAD.

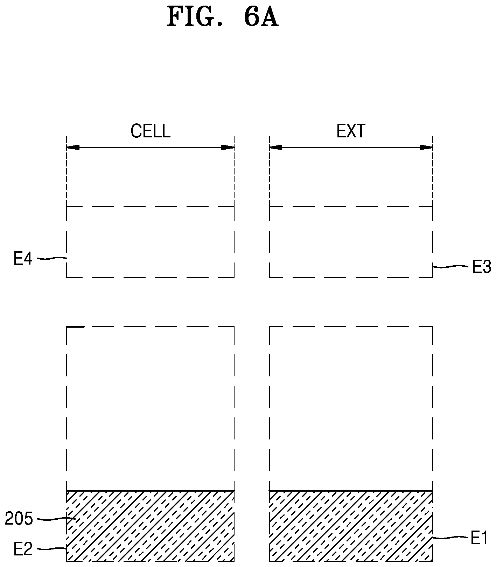

FIGS. 6A to 6Q are cross-sectional views illustrating a method of manufacturing a nonvolatile memory device, according to some example embodiments. Particularly, FIGS. 6A to 6Q are shown by being rotated by 180 degrees (upside down or left and right reverse) when compared to FIGS. 5A and 5B and are magnified views of portions respectively corresponding to the portions E1, E2, E3, and E4 of FIGS. 5A and 5B.

Referring to FIG. 6A, a base substrate 205 having the cell region CELL and the connection region EXT is prepared. The base substrate 205 may include a semiconductor material, for example, a Group IV semiconductor material, a Group III-V semiconductor material, a Group II-VI semiconductor material, or a Group II-VI oxide semiconductor material. In some example embodiments, the base substrate 205 may be a silicon substrate.

Referring to FIG. 6B, the buffer insulating layer 214 is formed on the base substrate 205. The buffer insulating layer 214 may include an insulating material, such as silicon oxide, a low-k material, or a combination thereof. The buffer insulating layer 214 may be formed to have the first thickness T1.

Portions of the buffer insulating layer 214 are removed to form the plurality of buffer recesses 290R extending inward from the upper surface of the buffer insulating layer 214. Each of the plurality of buffer recesses 290R may be formed to have a first depth R1. The first depth R1 may be less than the first thickness T1. The plurality of buffer recesses 290R may extend from the upper surface of the buffer insulating layer 214 but not to the base substrate 205. For example, the first depth R1 may be about or exactly 20 nm to about or exactly 70 nm.

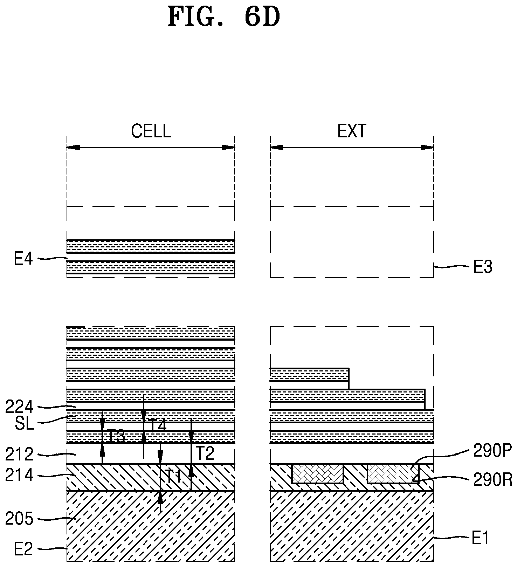

Referring to FIG. 6C, a plurality of preliminary contact stop layers 290P respectively filling the plurality of buffer recesses 290R are formed. The plurality of preliminary contact stop layers 290P may include a material having an etching selectivity with respect to a plurality of sacrificial layers SL and the plurality of insulating layers 224 shown in FIG. 6D. In some example embodiments, the plurality of preliminary contact stop layers 290P may include a metal. For example, the plurality of preliminary contact stop layers 290P may include W, molybdenum (Mo), TiN, or the like but are not limited thereto.

Each of the plurality of preliminary contact stop layers 290P may be formed to have a first height H1. The first height H1 may be less than the first thickness T1. The first height H1 may be substantially the same or the same as the first depth R1 (see FIG. 6B). For example, the first height H1 may be about or exactly 20 nm to about or exactly 70 nm.

Referring to FIG. 6D, the base insulating layer 212 covering the buffer insulating layer 214 and the plurality of preliminary contact stop layers 290P is formed, and then, the plurality of sacrificial layers SL and the plurality of insulating layers 224 alternately on the base insulating layer 212 are formed. The sacrificial layer SL and the insulating layer 224 may include materials having etching selectivities with respect to each other. For example, the sacrificial layer SL may include nitride, and the insulating layer 224 may include oxide, but the sacrificial layer SL and the insulating layer 224 are not limited thereto. The base insulating layer 212 and the insulating layer 224 may include materials having the same or similar etching characteristics. For example, the base insulating layer 212 may include oxide. The base insulating layer 212 may have the second thickness T2, the sacrificial layer SL may have the third thickness T3, and the insulating layer 224 may have the fourth thickness T4.

Thereafter, portions of the plurality of sacrificial layers SL and portions of the plurality of insulating layers 224 in the connection region EXT are removed such that the plurality of sacrificial layers SL and the plurality of insulating layers 224 have a staircase shape in the connection region EXT.

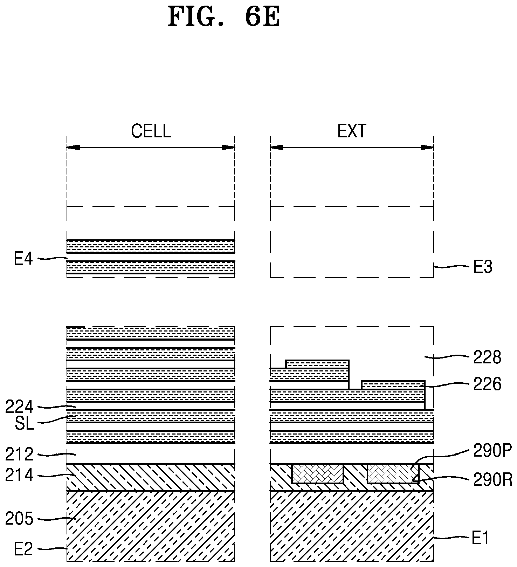

Referring to FIG. 6E, a plurality of extended sacrificial layers 226 are respectively formed on portions of the plurality of sacrificial layers SL of a staircase shape in the connection region EXT. The extended sacrificial layer 226 may include a material having the same or similar etching characteristic as or to that of the sacrificial layer SL. For example, the extended sacrificial layer 226 may include nitride. The plurality of extended sacrificial layers 226 may at least partially overlap the plurality of preliminary contact stop layers 290P in the vertical direction, respectively.

The filling insulating layer 228 covering the plurality of sacrificial layers SL, the plurality of insulating layers 224, and the plurality of extended sacrificial layers 226 is formed. The filling insulating layer 228 may be formed to have an upper surface at substantially the same or the same vertical level in each of the cell region CELL and the connection region EXT.

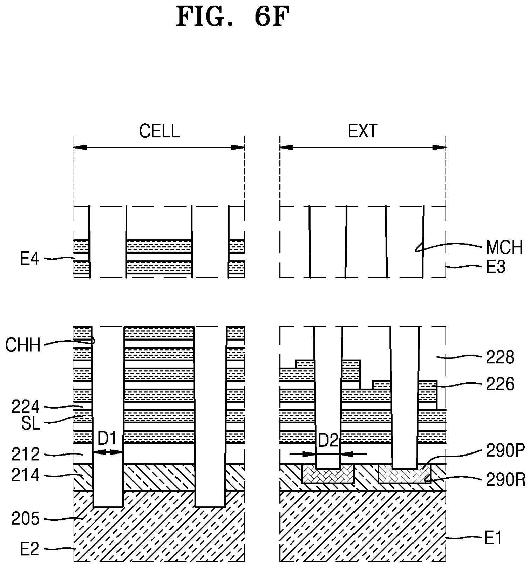

Referring to FIG. 6F, in the cell region CELL, the plurality of channel holes CHH extending to the inside of the base substrate 205 by passing through the filling insulating layer 228, the plurality of sacrificial layers SL, the plurality of insulating layers 224, the base insulating layer 212, and the buffer insulating layer 214 are formed, and in the connection region EXT, the plurality of contact holes MCH passing through the filling insulating layer 228, the plurality of extended sacrificial layers 226, the plurality of sacrificial layers SL, the plurality of insulating layers 224, and the base insulating layer 212 are formed. The base substrate 205 may be exposed through the bottom surfaces of the plurality of channel holes CHH, and the plurality of preliminary contact stop layers 290P may be exposed through the bottom surfaces of the plurality of contact holes MCH, respectively. In a process of forming the plurality of channel holes CHH and the plurality of contact holes MCH, the dummy channel hole DCH (see FIG. 5A) may be formed together.

Each of the plurality of channel holes CHH may have the first horizontal diameter D1 in the horizontal direction, and each of the plurality of contact holes MCH may have the second horizontal diameter D2 in the horizontal direction. The second horizontal diameter D2 may be less than the first horizontal width W1 (see FIG. 6C). At the same vertical level, the second horizontal diameter D2 may be greater than or equal to the first horizontal diameter D1. In some example embodiments, the diameter of the first horizontal diameter D1 and the second horizontal diameter D2 may be the same or substantially the same along their respective lengths.

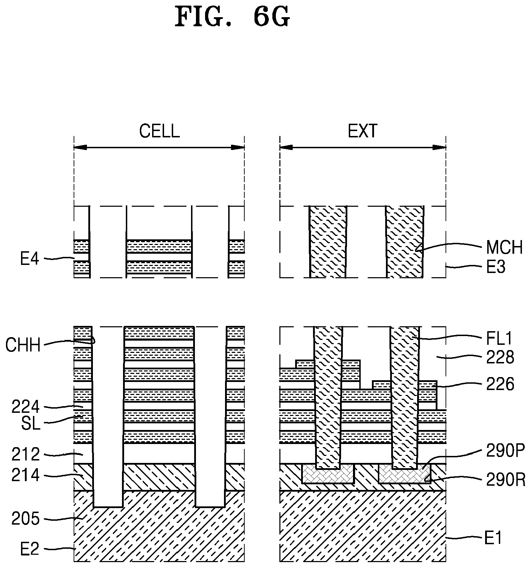

Referring to FIG. 6G, a plurality of first filling sacrificial layers FL1 respectively filling the plurality of contact holes MCH are formed. The plurality of first filling sacrificial layers FL1 may include a material having an etching selectivity with respect to the plurality of sacrificial layers SL, the plurality of insulating layers 224, and the plurality of extended sacrificial layers 226. For example, the plurality of first filling sacrificial layers FL1 may include a material having the same or similar etching characteristic as or to that of the plurality of preliminary contact stop layers 290P. In some example embodiments, the plurality of first filling sacrificial layers FL1 and the plurality of preliminary contact stop layers 290P may include the same material.

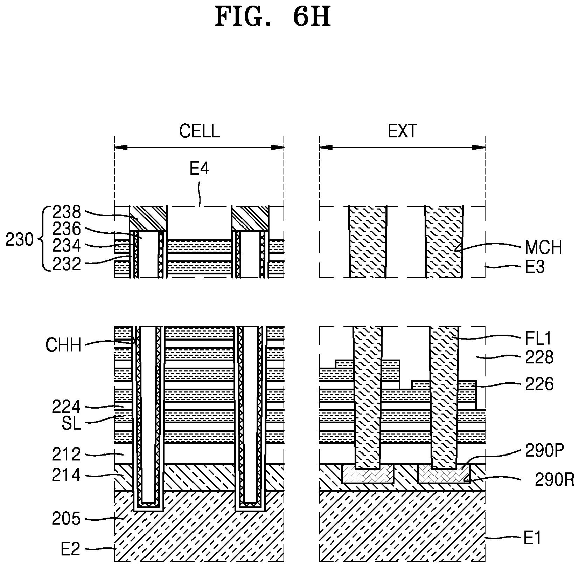

Referring to FIG. 6H, the plurality of cell channel structures 230 respectively filling the plurality of channel holes CHH are formed. Each of the plurality of cell channel structures 230 may include the gate insulating layer 232, the channel layer 234, the buried insulating layer 236, and the conductive plug 238.

The gate insulating layer 232 and the channel layer 234 may be sequentially formed on the inner wall and the bottom surface of each of the plurality of channel holes CHH. The gate insulating layer 232 and the channel layer 234 may sequentially and conformally cover the inner wall and the bottom surface of each of the plurality of channel holes CHH. The gate insulating layer 232 may cover the surface of each of the plurality of sacrificial layers SL, the plurality of insulating layers 224, the base insulating layer 212, and the buffer insulating layer 214 exposed through each of the plurality of channel holes CHH.

The buried insulating layer 236 filling a remaining space of each of the plurality of channel holes CHH on the channel layer 234 of each of the plurality of channel holes CHH may be formed. The conductive plug 238 covering the entrance of the channel hole CHH while being in contact with the channel layer 234 may be formed on each of the plurality of channel holes CHH. In some example embodiments, the buried insulating layer 236 may be omitted, and the channel layer 234 may be formed in a pillar shape filling the remaining space of the channel hole CHH.

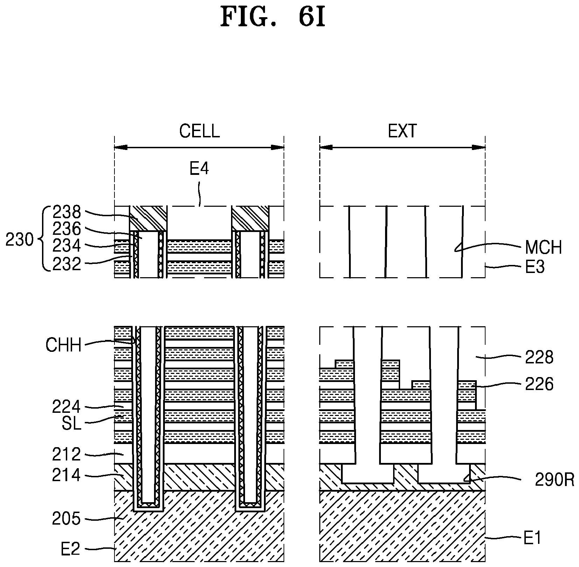

Referring to FIGS. 6H and 6I, the plurality of first filling sacrificial layers FL1 and the plurality of preliminary contact stop layers 290P are removed. The plurality of contact holes MCH may communicate with the plurality of buffer recesses 290R, respectively. The filling insulating layer 228, the plurality of extended sacrificial layers 226, the plurality of insulating layers 224, the plurality of sacrificial layers SL, the base insulating layer 212, and the buffer insulating layer 214 may be exposed through the plurality of contact holes MCH and the plurality of buffer recesses 290R.

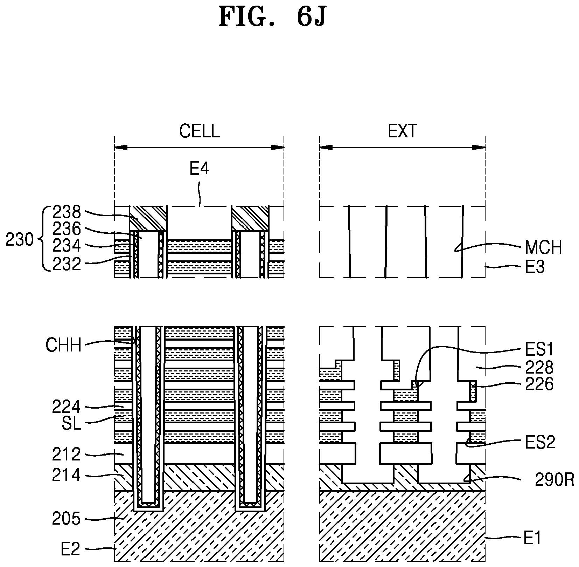

Referring to FIGS. 6I and 6J, portions of the plurality of extended sacrificial layers 226 and portions of the plurality of sacrificial layers SL are removed through the plurality of contact holes MCH to form the plurality of first extended spaces ES1 and the plurality of second extended spaces ES2 communicating with the plurality of contact holes MCH.

The plurality of first extended spaces ES1 may be formed by removing portions of the plurality of extended sacrificial layers 226 and portions of the plurality of sacrificial layers SL, which are respectively in contact with the portions of the plurality of extended sacrificial layers 226. The plurality of second extended spaces ES2 may be formed by removing portions of the plurality of sacrificial layers SL, which are respectively not in contact with the plurality of extended sacrificial layers 226.

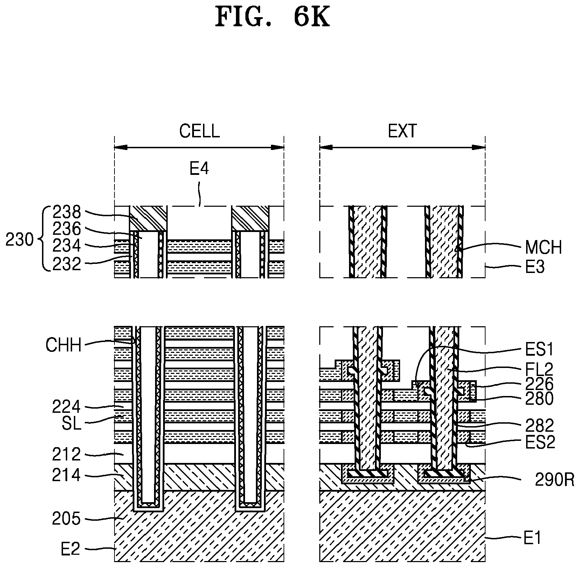

Referring to FIG. 6K, a spacer material layer 280 filling portions of the plurality of first extended spaces ES1 and portions of the plurality of buffer recesses 290R and filling all of the plurality of second extended spaces ES2 is formed, and then, a cover protection layer 282 covering the spacer material layer 280 and a second filling sacrificial layer FL2 filling the plurality of contact holes MCH and the plurality of buffer recesses 290R are formed. For example, the spacer material layer 280 may include oxide, and the cover protection layer 282 may include nitride, but the spacer material layer 280 and the cover protection layer 282 are not limited thereto.

The spacer material layer 280 may be formed by forming a preliminary spacer material layer conformally covering the inner surfaces of the plurality of contact holes MCH, the plurality of first extended spaces ES1, the plurality of second extended spaces ES2, and the plurality of buffer recesses 290R and then removing a portion of the preliminary spacer material layer covering the inner walls of the plurality of contact holes MCH. The preliminary spacer material layer may be formed to have a thickness greater than 1/2 the sixth thickness T6 (see FIG. 5B) and less than 1/2 the fifth thickness T5 (see FIG. 5B) such that the preliminary spacer material layer fills all of the plurality of second extended spaces ES2 and fills only portions of the plurality of first extended spaces ES1. The cover protection layer 282 may be formed to fill the remaining portions of the plurality of first extended spaces ES1 and not to fill all of the plurality of contact holes MCH. The second filling sacrificial layer FL2 may be formed to fill all of the plurality of contact holes MCH.

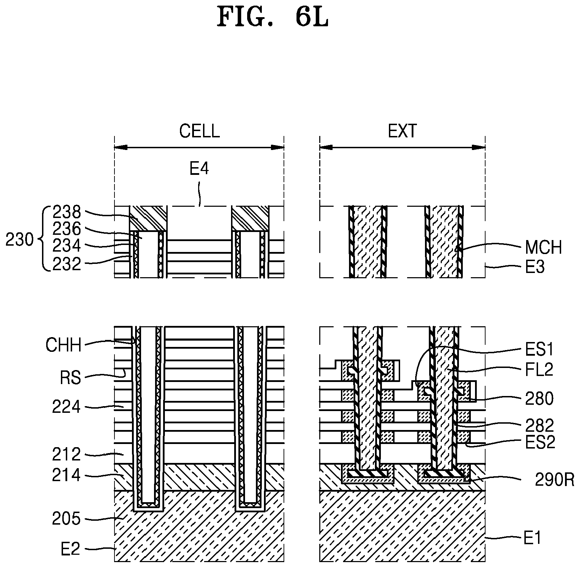

Referring to FIGS. 6K and 6L, a plurality of removed spaces RS are formed by removing the plurality of sacrificial layers SL and the plurality of extended sacrificial layers 226. The plurality of removed spaces RS may be formed by forming a gate cut region passing through the plurality of sacrificial layers SL and the plurality of insulating layers 224 and then removing the plurality of sacrificial layers SL through the gate cut region.

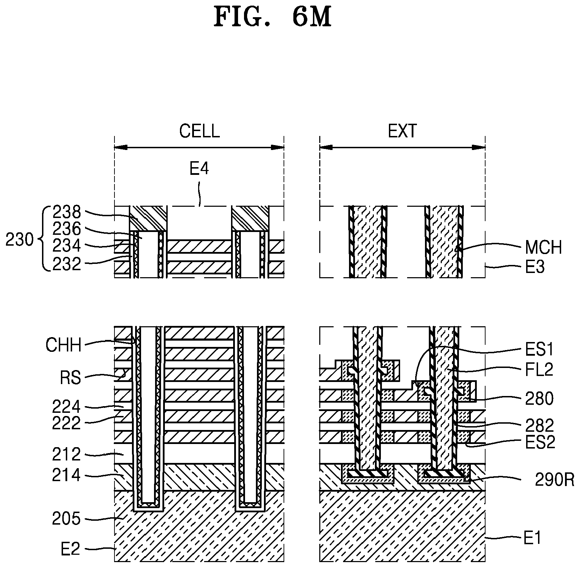

Referring to FIG. 6M, the plurality of gate electrodes 222 filling the plurality of removed spaces RS are formed. Each of the plurality of gate electrodes 222 may include the barrier electrode layer 222B (see FIG. 5B) and the main electrode layer 222M (see FIG. 5B). The barrier electrode layer 222B may be formed to conformally cover the inner surface of each of the plurality of removed spaces RS, and the main electrode layer 222M may be formed to fill each of the plurality of removed spaces RS while covering the barrier electrode layer 222B.

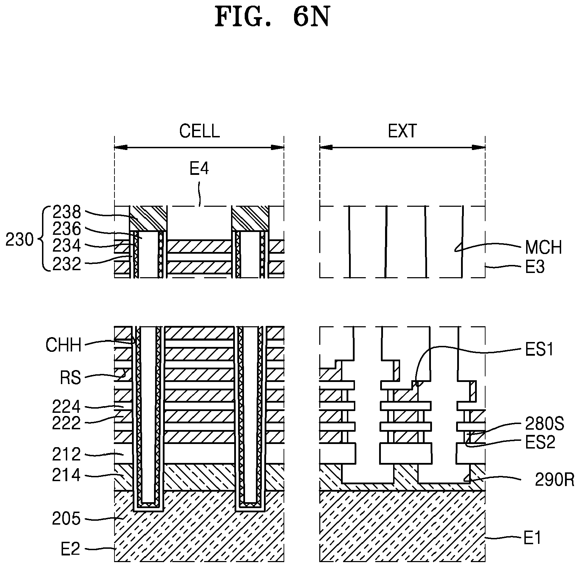

Referring to FIGS. 6M and 6N, a plurality of insulating spacers 280S are respectively formed in the plurality of second extended spaces ES2 by removing the second filling sacrificial layer FL2 and the cover protection layer 282 and then removing a portion of the spacer material layer 280. All portions of the spacer material layer 280 in the plurality of first extended spaces ES1 may be removed. The plurality of insulating spacers 280S may cover side surfaces of corresponding ones of the plurality of gate electrodes 222 facing the plurality of second extended spaces ES2. That is, the plurality of insulating spacers 280S may be between the plurality of second extended spaces ES2 and corresponding ones of the plurality of gate electrodes 222.

The plurality of gate electrodes 222 may be in contact with the gate insulating layer 232 of each of the plurality of cell channel structures 230. The gate insulating layer 232 may be between the channel layer 234 of each of the plurality of cell channel structures 230 and the plurality of gate electrodes 222.

Referring to FIG. 60, a conductive material layer filling the plurality of contact holes MCH, the plurality of first extended spaces ES1, the plurality of second extended spaces ES2, and the plurality of buffer recesses 290R is formed. A portion of the conductive material layer filling the plurality of contact holes MCH, the plurality of first extended spaces ES1, and the plurality of second extended spaces ES2 may be the plurality of cell contact structures 270, and a portion of the conductive material layer filling the plurality of buffer recesses 290R may be the plurality of contact stop layers 290. Each of the plurality of contact stop layers 290 may be referred to as a contact stop portion of each of the plurality of cell contact structures 270.

Each of the plurality of cell contact structures 270 may include the barrier contact layer 270B (see FIG. 5B) and the main contact layer 270M (see FIG. 5B). The barrier contact layer 270B may be formed by conformally covering the inner surface of each of the plurality of contact holes MCH, the plurality of first extended spaces ES1, the plurality of second extended spaces ES2, and the plurality of buffer recesses 290R, and the main contact layer 270M may be formed to fill the plurality of contact holes MCH, the plurality of first extended spaces ES1, the plurality of second extended spaces ES2, and the plurality of buffer recesses 290R while covering the barrier contact layer 270B.

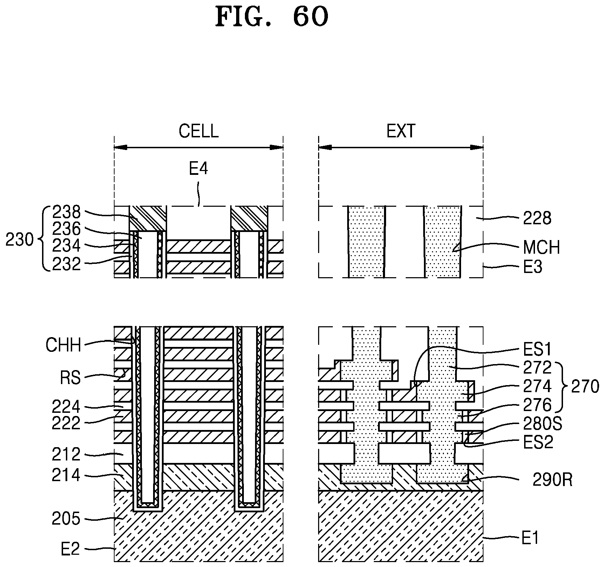

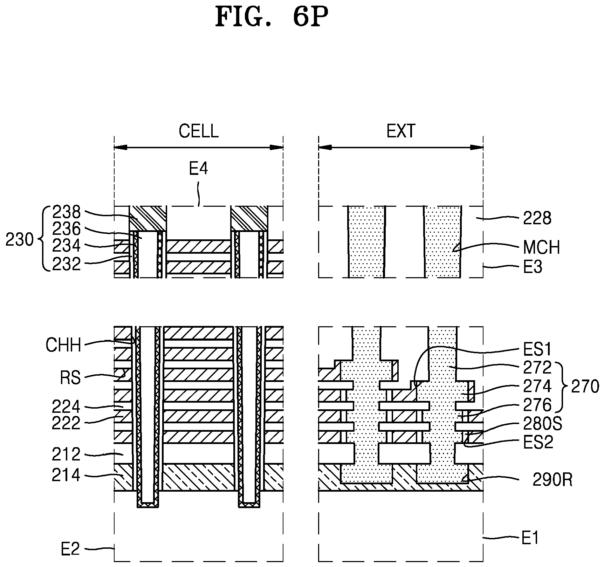

Referring to FIGS. 6O and 6P, the base substrate 205 is removed. Before removing the base substrate 205, a result of FIG. 6O may be upside down, and then, the base substrate 205 may be removed.

The base substrate 205 is removed, and portions of the gate insulating layers 232 among portions of the plurality of cell channel structures 230, which are exposed from the lower surface of the buffer insulating layer 214 (when the result of FIG. 6O is upside down, the upper surface of the buffer insulating layer 214 as shown in FIGS. 5A and 5B), are removed to expose portions of the channel layers 234 of the plurality of cell channel structures 230.

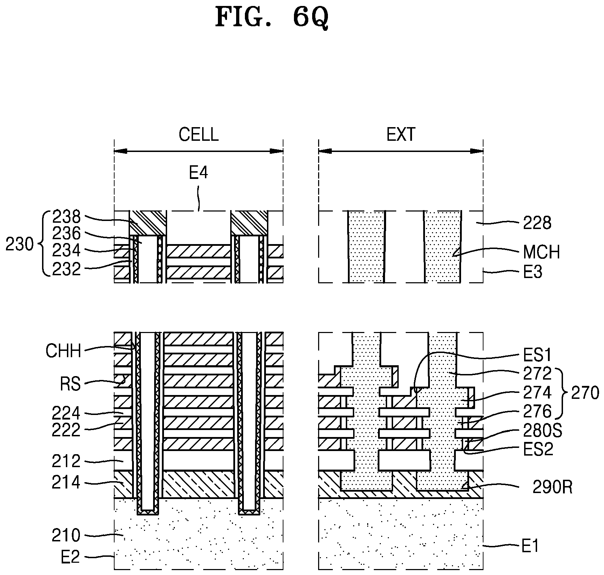

Referring to FIG. 6Q, the common source line layer 210 covering the plurality of cell channel structures 230 is formed beneath the lower surface of the buffer insulating layer 214. The common source line layer 210 may be in contact with the channel layers 234 of the plurality of cell channel structures 230.

After forming the common source line layer 210, the cell array structure CS shown in FIG. 5A may be formed by forming a plurality of bit line contacts BLC, the plurality of bit lines BL, a plurality of second interconnect structures 240, a plurality of second bonding pads 260, and the second insulating structure 250 shown in FIG. 5A on the filling insulating layer 228, the plurality of cell channel structures 230, and the plurality of cell contact structures 270, and the nonvolatile memory device 100 shown in FIGS. 5A and 5B may be formed by bonding the cell array structure CS and the peripheral circuit structure PS to each other by metal-oxide hybrid bonding.

Referring to FIGS. 5A to 6Q, in a process of forming the plurality of contact holes MCH, the numbers of gate electrodes 222 and insulating layers 224 through which each contact hole MCH passes may vary, and thus, it may be difficult to uniformly control a depth of each of the plurality of contact holes MCH by adjusting an etching process condition. However, because the plurality of preliminary contact stop layers 290P function as etching stop layers in a process of forming the plurality of contact holes MCH, the plurality of contact holes MCH may be formed to have a uniform depth, and because the plurality of contact holes MCH do not pass through the buffer insulating layer 214, the plurality of contact holes MCH may not extend to the common source line layer 210. Therefore, the nonvolatile memory device 100 according to the inventive concepts may prevent or reduce the plurality of cell contact structures 270 from being connected to the common source line layer 210, thereby ensuring or improving electrical operation reliability.

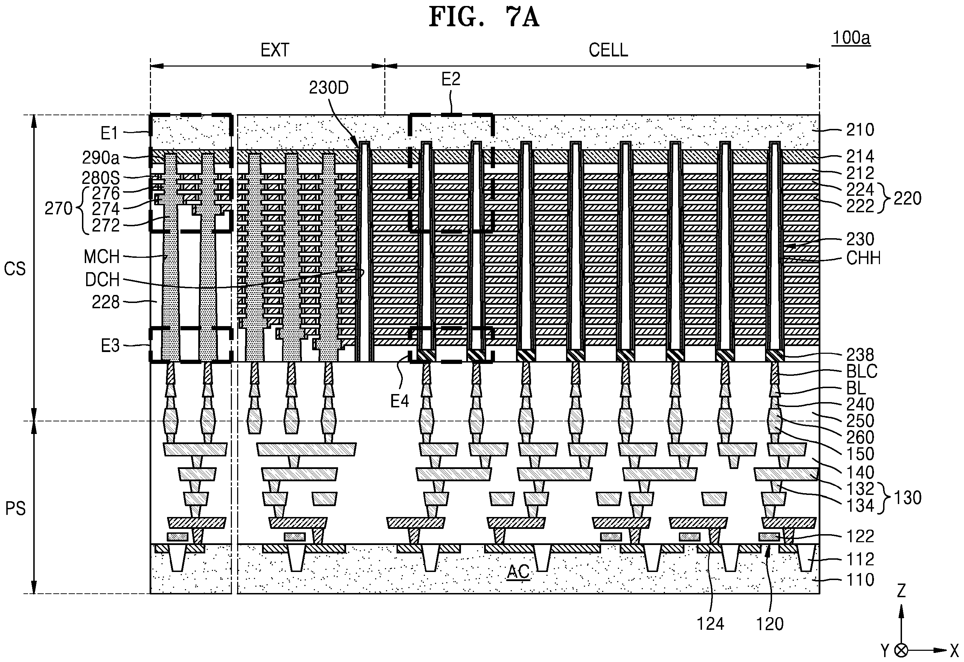

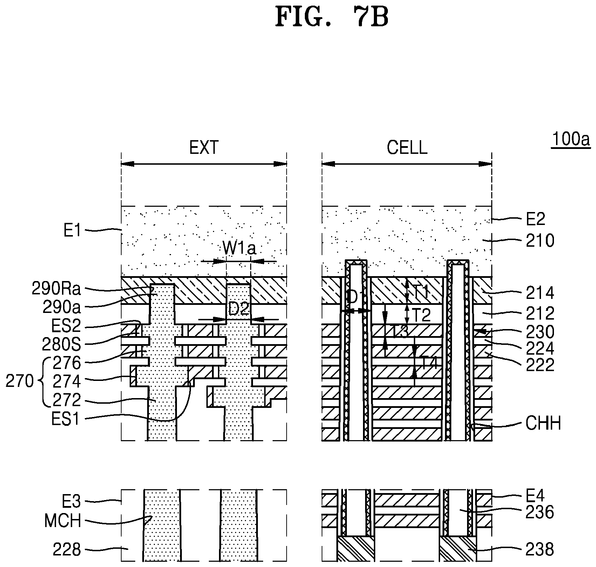

FIGS. 7A and 7B are cross-sectional views of a nonvolatile memory device 100a according to some example embodiments. Particularly, FIG. 7B show magnified views of portions E1, E2, E3, and E4 of FIG. 7A.

Instead of the plurality of buffer recesses 290R and the plurality of contact stop layers 290 filling the plurality of buffer recesses 290R, which are included in the nonvolatile memory device 100 shown in FIGS. 5A and 5B, the nonvolatile memory device 100a shown in FIGS. 7A and 7B may include a plurality of buffer recesses 290Ra and a plurality of contact stop layers 290a filling the plurality of buffer recesses 290Ra.

Each of the plurality of contact stop layers 290a or the plurality of buffer recesses 290Ra may have a first horizontal width W1a. At a vertical level where the buffer insulating layer 214 is in contact with the base insulating layer 212, the first horizontal width W1a may be generally the same as the second horizontal diameter D2. For example, the first horizontal width W1a may be about or exactly 100 nm to about or exactly 150 nm.

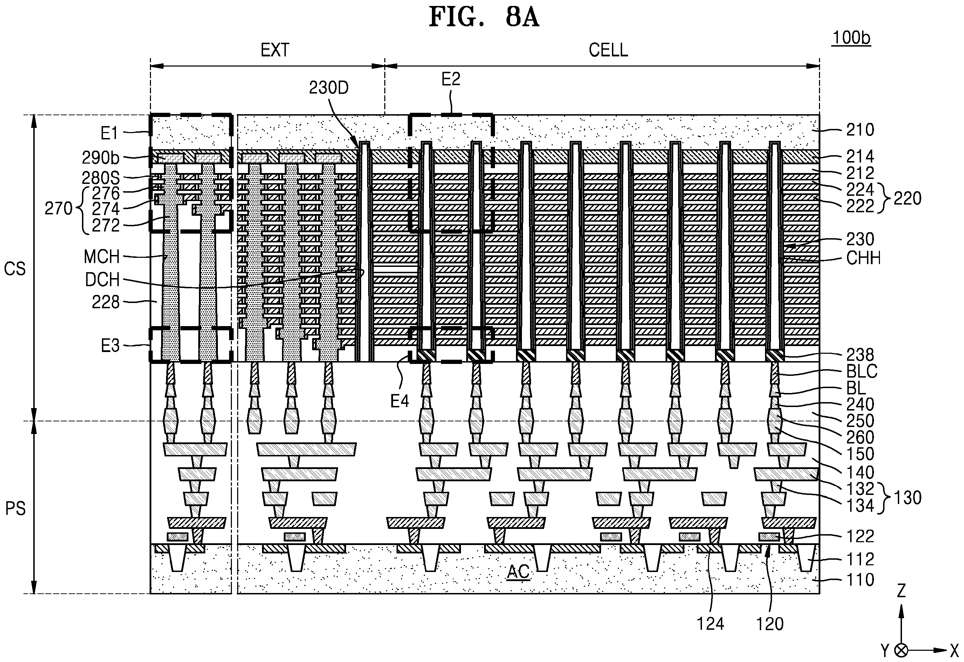

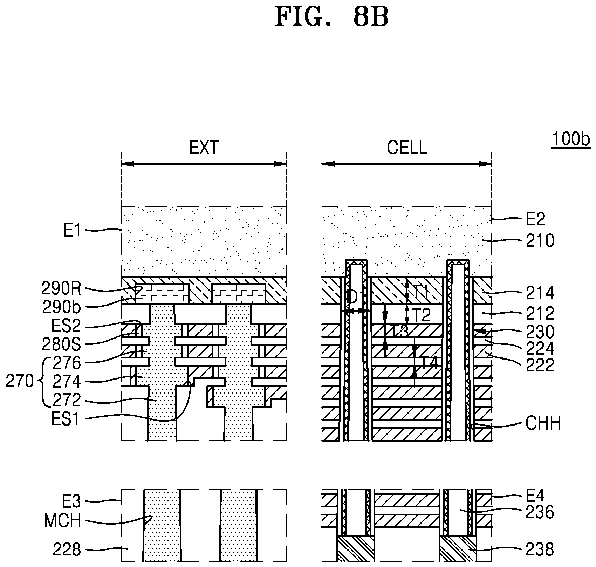

FIGS. 8A and 8B are cross-sectional views of a nonvolatile memory device 100b according to some example embodiments. Particularly, FIG. 8B show magnified views of portions E1, E2, E3, and E4 of FIG. 8A.

Instead of the plurality of contact stop layers 290 filling the plurality of buffer recesses 290R, which are included in the nonvolatile memory device 100 shown in FIGS. 5A and 5B, the nonvolatile memory device 100b shown in FIGS. 8A and 8B may include a plurality of contact stop layers 290b filling the plurality of buffer recesses 290R. For example, the plurality of contact stop layers 290b may include a non-metal material.

The plurality of contact stop layers 290b may include a material different from that of the plurality of cell contact structures 270. For example, the plurality of contact stop layers 290b may be formed by forming the plurality of contact stop layers 290b including a non-metal material instead of the plurality of preliminary contact stop layers 290P shown in FIG. 6C, which include a metal, and then removing only the plurality of first filling sacrificial layers FL1 in a process of removing the plurality of first filling sacrificial layers FL1 and the plurality of preliminary contact stop layers 290P shown in FIGS. 6H and 6I.

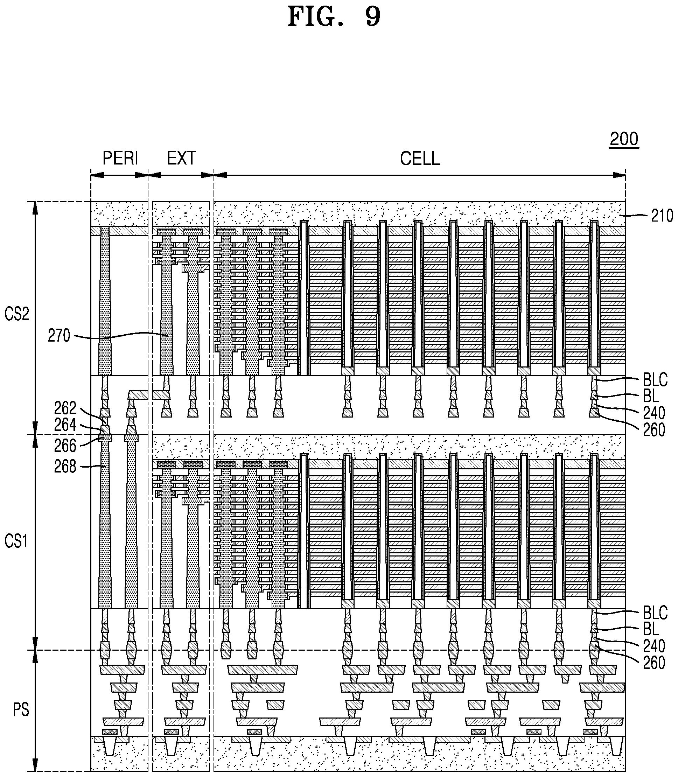

FIG. 9 is a cross-sectional view of a nonvolatile memory device 200 having a cell-to-cell (C2C) structure, according to some example embodiments.

Referring to FIG. 9, unlike the nonvolatile memory device 100 shown in FIGS. 5A and 5B, the nonvolatile memory device 200 of FIG. 9 may include the peripheral circuit structure PS, a first cell array structure CS1, and a second cell array structure CS2, which are bonded to one another in the vertical direction (the Z direction). The first cell array structure CS1 and the second cell array structure CS2 are generally the same as the cell array structure CS shown in FIGS. 5A and 5B, and thus, a description made with respect to the cell array structure CS is not repeated. For example, the peripheral circuit structure PS and the first cell array structure CS1 may be bonded to each other by metal-oxide hybrid bonding, and the first cell array structure CS1 and the second cell array structure CS2 may be bonded to each other by metal-oxide hybrid bonding.

The common source line layer 210 and the plurality of cell contact structures 270 of the second cell array structure CS2 may be electrically connected to the peripheral circuit structure PS via a plurality of connection vias 268 in the cell peripheral circuit region PERI. For example, the common source line layer 210 of the second cell array structure CS2 may be electrically connected to the peripheral circuit structure PS via a connection via 268 in the second cell array structure CS2 and a connection via 268 in the first cell array structure CS1. The plurality of cell contact structures 270 of the second cell array structure CS2 may be electrically connected to the peripheral circuit structure PS via connection vias 268 in the first cell array structure CS1. Although not separately shown in FIG. 9, the common source line layer 210 of the first cell array structure CS1 may be electrically connected to the peripheral circuit structure PS via the connection vias 268 in the first cell array structure CS1.

The second cell array structure CS2 may be electrically connected to the first cell array structure CS1 via a plurality of connection wiring layers 262 and a plurality of connection contacts 264. The connection via 268 and/or the plurality of cell contact structures 270 in the second cell array structure CS2 may be electrically connected to the plurality of connection wiring layers 262 and the plurality of connection contacts 264. In some example embodiments, a plurality of connection pads 266 may be respectively on the connection vias 268 in the first cell array structure CS1. The plurality of connection pads 266 may be exposed on an upper surface of the first cell array structure CS1. The plurality of connection contacts 264 in the second cell array structure CS2 may be connected to the plurality of connection pads 266 in the first cell array structure CS1, respectively.

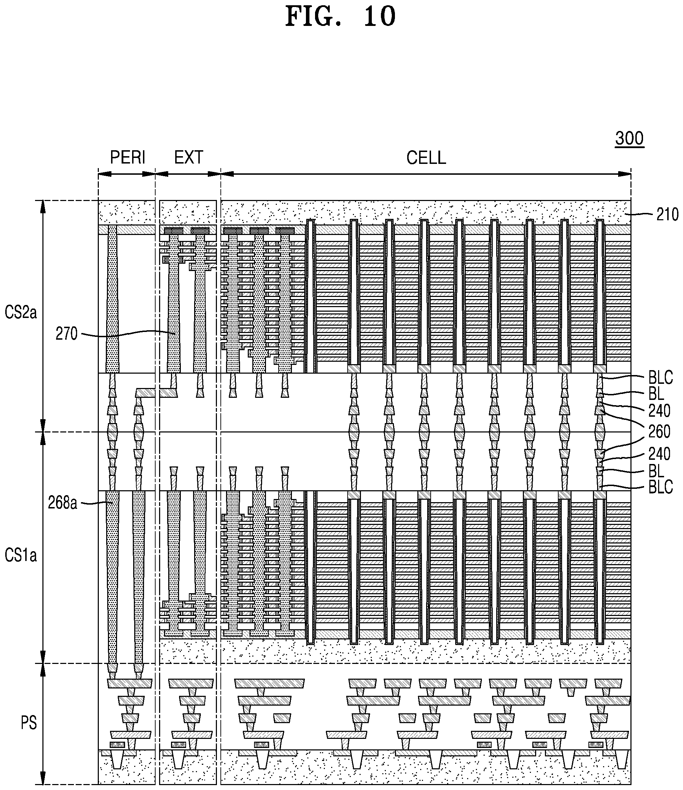

FIG. 10 is a cross-sectional view of a nonvolatile memory device 300 having a C2C structure, according to some example embodiments.

Referring to FIG. 10, unlike the nonvolatile memory device 100 shown in FIGS. 5A and 5B, the nonvolatile memory device 300 of FIG. 10 may include the peripheral circuit structure PS, a first cell array structure CS1a, and a second cell array structure CS2a, which are bonded to one another in the vertical direction (the Z direction). The first cell array structure CS1a and the second cell array structure CS2a are generally the same as the cell array structure CS shown in FIGS. 5A and 5B or the first cell array structure CS1 and the second cell array structure CS2 shown in FIG. 9, and thus, a description made with respect to the cell array structure CS or the first cell array structure CS1 and the second cell array structure CS2 is not repeated. Each of the first cell array structure CS1 and the second cell array structure CS2 shown in FIG. 9 has the common source line layer 210 at upper sides thereof like the cell array structure CS shown in FIGS. 5A and 5B, but the first cell array structure CS1a shown in FIG. 10 has the common source line layer 210 at a lower side thereof, and the second cell array structure CS2a has the common source line layer 210 as an upper side thereof. That is, the cell region CELL and the connection region EXT of the first cell array structure CS1a may be symmetrical to the cell region CELL and the connection region EXT of the second cell array structure CS2a in the vertical direction.

For example, the peripheral circuit structure PS and the first cell array structure CS1a may be bonded to each other by metal-oxide hybrid bonding, and the first cell array structure CS1a and the second cell array structure CS2a may be bonded to each other by metal-oxide hybrid bonding.

The common source line layer 210 and the plurality of cell contact structures 270 of the second cell array structure CS2a may be electrically connected to the peripheral circuit structure PS via a plurality of connection vias 268a in the cell peripheral circuit region PERI. For example, the common source line layer 210 of the second cell array structure CS2a may be electrically connected to the peripheral circuit structure PS via a connection via 268a in the second cell array structure CS2a and connection vias 268 in the first cell array structure CS1a. The plurality of cell contact structures 270 of the second cell array structure CS2a may be electrically connected to the peripheral circuit structure PS via the connection vias 268 in the first cell array structure CS1a.

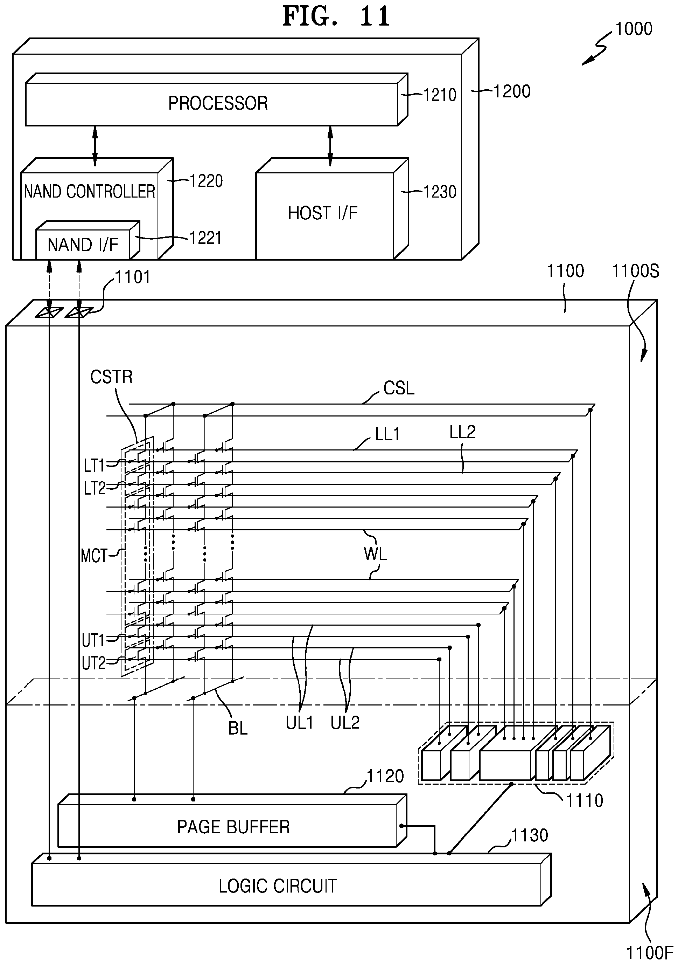

FIG. 11 is a block diagram schematically illustrating a memory system 1000 including a nonvolatile memory device, according to some example embodiments.

Referring to FIG. 11, the memory system 1000 may include at least one memory device 1100 and a memory controller 1200 electrically connected to the at least one memory device 1100. The memory system 1000 may be, for example, a solid state drive (SSD) device, a universal serial bus (USB) device, a computing system, a medical device, or a communication device including the at least one memory device 1100.

A memory device 1100 may be a nonvolatile memory device. For example, the memory device 1100 may be a NAND flash memory device including one or a combination of the nonvolatile memory devices 100, 100a, 100b, 200, and 300 described with reference to FIGS. 5A to 10. The memory device 1100 may include a first structure 1100F and a second structure 1100S on the first structure 1100F. The first structure 1100F may correspond to the peripheral circuit structure PS shown in FIGS. 5A, 7A, 8A, 9, and 10. The peripheral circuit 120 shown in FIGS. 5A, 7A, 8A, 9, and 10 may include a row decoder 1110, a page buffer 1120, and a logic circuit 1130.

The second structure 11005 may correspond to the cell array structure CS shown in FIGS. 5A to 8B or the first cell array structure CS1 and the second cell array structure CS2 shown in FIG. 9. The second structure 1 1005 may include the plurality of bit lines BL, the common source line CSL, the plurality of word lines WL, first and second string select lines UL1 and UL2, first and second ground select lines LL1 and LL2, and a plurality of memory cell strings CSTR between the plurality of bit lines BL and the common source line CSL. The plurality of cell channel structures 230 and the plurality of gate electrodes 222 shown in FIGS. 5A, 7A, 8A, 9, and 10 may form the plurality of memory cell strings CSTR.

In the second structure 1100S, each of the plurality of memory cell strings CSTR may include ground select transistors LT1 and LT2 adjacent to the common source line CSL, string select transistors UT1 and UT2 adjacent to a bit line BL, and a plurality of memory cell transistors MCT between the ground select transistors LT1 and LT2 and the string select transistors UT1 and UT2. The number of ground select transistors LT1 and LT2 and the number of string select transistors UT1 and UT2 may be variously modified according to some example embodiments. One of the plurality of cell channel structures 230 and one of the plurality of gate electrodes 222, which are shown in FIGS. 5A, 7A, 8A, 9, and 10, may form one of the ground select transistors LT1 and LT2, the string select transistors UT1 and UT2, and the plurality of memory cell transistors MCT.

In some example embodiments, the first and second ground select lines LL1 and LL2 may be connected to gate electrodes of the ground select transistors LT1 and LT2, respectively. The plurality of word lines WL may be connected to gate electrodes of the plurality of memory cell transistors MCT, respectively. The first and second string select lines UL1 and UL2 may be connected to gate electrodes of the string select transistors UT1 and UT2, respectively.

The common source line CSL, the first and second ground select lines LL1 and LL2, the plurality of word lines WL, and the first and second string select lines UL1 and UL2 may be electrically connected to the row decoder 1110. The plurality of bit lines BL may be electrically connected to the page buffer 1120.

The memory device 1100 may communicate with the memory controller 1200 through external connection pads 1101 electrically connected to the logic circuit 1130. The external connection pads 1101 may be electrically connected to the logic circuit 1130.

The memory controller 1200 may include a processor 1210, a NAND controller 1220, and a host interface (I/F) 1230. In some example embodiments, the memory system 1000 may include a plurality of memory devices 1100, and in this case, the memory controller 1200 may control the plurality of memory devices 1100.

The processor 1210 may control a general operation of the memory system 1000 including the memory controller 1200. The processor 1210 may operate according to certain firmware and control the NAND controller 1220 to access the memory device 1100. The NAND controller 1220 may include a NAND interface (I/F) 1221 configured to process communication with the memory device 1100. Through the NAND interface 1221, a control command for controlling the memory device 1100, data to be written on the plurality of memory cell transistors MCT in the memory device 1100, data read from the plurality of memory cell transistors MCT in the memory device 1100, and the like may be transferred. The host interface 1230 may provide a communication function between the memory system 1000 and an external host. When a control command is received from the external host through the host interface 1230, the processor 1210 may control the memory device 1100 in response to the control command.

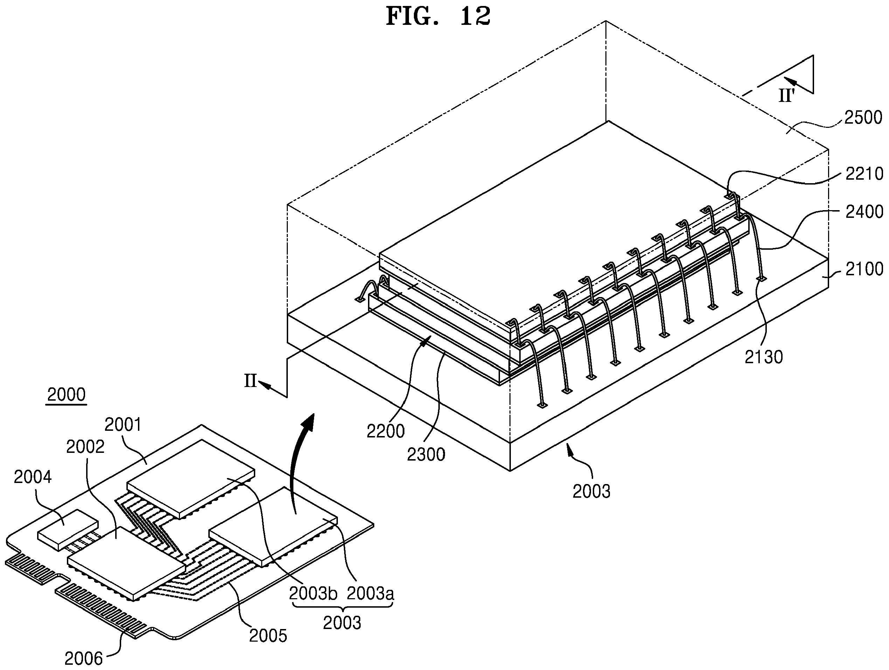

FIG. 12 is a perspective view schematically illustrating a memory system 2000 including a nonvolatile memory device, according to some example embodiments.

Referring to FIG. 12, the memory system 2000 according to some example embodiments may include a main substrate 2001 and a memory controller 2002, a semiconductor package 2003, and dynamic random access memory (DRAM) 2004 mounted on the main substrate 2001. The semiconductor package 2003 and the DRAM 2004 may be connected to the memory controller 2002 through a plurality of wiring patterns 2005 formed on the main substrate 2001.

The main substrate 2001 may include a connector 2006 including a plurality of pins coupled to an external host. The number and the arrangement of pins in the connector 2006 may vary according to a communication interface between the memory system 2000 and the external host. In some example embodiments, the memory system 2000 may communicate with the external host according to any one of interfaces, such as a USB interface, a peripheral component interconnect express (PCI-Express) interface, a serial advanced technology attachment (SATA) interface, and an M-Phy interface for a universal flash storage (UFS). In some example embodiments, the memory system 2000 may operate by power received from the external host through the connector 2006. The memory system 2000 may further include a power management integrated circuit (PMIC) configured to distribute the power received from the external host to the memory controller 2002 and the semiconductor package 2003.

The memory controller 2002 may write or read data on or from the semiconductor package 2003 and improve an operating speed of the memory system 2000.

The DRAM 2004 may be a buffer memory configured to mitigate a speed difference between the semiconductor package 2003, which is a data storage space, and the external host. The DRAM 2004 included in the memory system 2000 may operate as a kind of cache memory and provide a space in which data is temporarily stored in a control operation on the semiconductor package 2003. When the DRAM 2004 is included in the memory system 2000, the memory controller 2002 may further include a DRAM controller configured to control the DRAM 2004 in addition to a NAND controller configured to control the semiconductor package 2003.

The semiconductor package 2003 may include first and second semiconductor packages 2003a and 2003b separated from each other. Each of the first and second semiconductor packages 2003a and 2003b may include a plurality of semiconductor chips 2200. Each of the first and second semiconductor packages 2003a and 2003b may include a package substrate 2100, the plurality of semiconductor chips 2200 on the package substrate 2100, an adhesive layer 2300 beneath a lower surface of each of the plurality of semiconductor chips 2200, a plurality of connection structures 2400 electrically connecting the plurality of semiconductor chips 2200 to the package substrate 2100, and a molding layer 2500 covering the plurality of semiconductor chips 2200 and the plurality of connection structures 2400 on the package substrate 2100.

The package substrate 2100 may be a printed circuit board including a plurality of package upper pads 2130. Each of the plurality of semiconductor chips 2200 may include input-output pads 2210. Each of the plurality of semiconductor chips 2200 may include at least one of the nonvolatile memory devices 100, 100a, 100b, 200, and 300 described with reference to FIGS. 5A to 10.

In some example embodiments, the plurality of connection structures 2400 may be bonding wires electrically connecting the input-output pads 2210 to the plurality of package upper pads 2130. Therefore, in the first and second semiconductor packages 2003a and 2003b, the plurality of semiconductor chips 2200 may be electrically connected to each other by a bonding wire scheme and electrically connected to the plurality of package upper pads 2130 of the package substrate 2100. In some example embodiments, in the first and second semiconductor packages 2003a and 2003b, the plurality of semiconductor chips 2200 may be electrically connected to each other through a connection structure including through silicon vias (TSVs) instead of the plurality of connection structures 2400 of the bonding wire scheme.

In some example embodiments, the memory controller 2002 and the plurality of semiconductor chips 2200 may be included in one package. In some example embodiments, the memory controller 2002 and the plurality of semiconductor chips 2200 may be mounted on a separate interposer substrate other than the main substrate 2001, and the memory controller 2002 may be connected to the plurality of semiconductor chips 2200 through wirings formed on the interposer substrate.

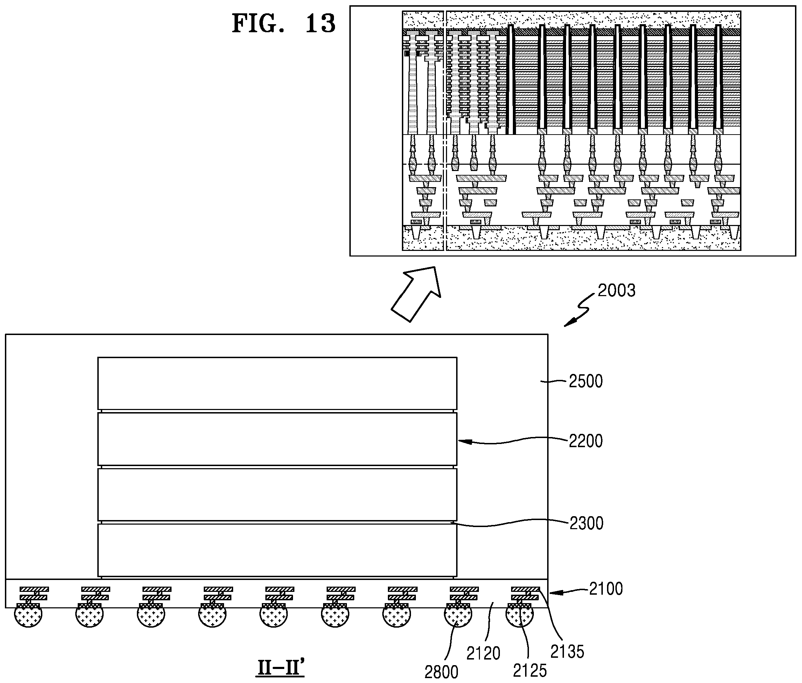

FIG. 13 is a cross-sectional view schematically illustrating the semiconductor package 2003 according to some example embodiments.

Referring to FIG. 13, in the semiconductor package 2003, the package substrate 2100 may be a printed circuit board. The package substrate 2100 may include a package substrate body portion 2120, the plurality of package upper pads 2130 (see FIG. 12) on an upper surface of the package substrate body portion 2120, a plurality of lower pads 2125 disposed on or exposed through a lower surface of the package substrate body portion 2120, and a plurality of internal wirings 2135 inside the package substrate body part 2120 to electrically connect the plurality of package upper pads 2130 (see FIG. 12) to the plurality of lower pads 2125. As shown in FIG. 12, the plurality of package upper pads 2130 may be electrically connected to the plurality of connection structures 2400. The plurality of lower pads 2125 may be connected, through a plurality of conductive bumps 2800, to the plurality of wiring patterns 2005 on the main substrate 2001 of the memory system 2000 shown in FIG. 12. Each of the plurality of semiconductor chips 2200 may include at least one of the nonvolatile memory devices 100, 100a, 100b, 200, and 300 described with reference to FIGS. 5A to 10.

When the terms "about" or "substantially" are used in this specification in connection with a numerical value, it is intended that the associated numerical value includes a manufacturing or operational tolerance (e.g., ±10 %) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10 %) around the stated numerical values or shapes.

As described herein, any electronic devices and/or portions thereof according to any of the example embodiments may include, may be included in, and/or may be implemented by one or more instances of processing circuitry such as hardware including logic circuits; a hardware/software combination such as a processor executing software; or any combination thereof. For example, the processing circuitry more specifically may include, but is not limited to, a central processing unit (CPU), an arithmetic logic unit (ALU), a graphics processing unit (GPU), an application processor (AP), a digital signal processor (DSP), a microcomputer, a field programmable gate array (FPGA), and programmable logic unit, a microprocessor, application-specific integrated circuit (ASIC), a neural network processing unit (NPU), an Electronic Control Unit (ECU), an Image Signal Processor (ISP), and the like. In some example embodiments, the processing circuitry may include a non-transitory computer readable storage device (e.g., a memory), for example a DRAM device, storing a program of instructions, and a processor (e.g., CPU) configured to execute the program of instructions to implement the functionality and/or methods performed by some or all of any devices, systems, modules, units, controllers, circuits, architectures, and/or portions thereof according to any of the example embodiments, and/or any portions thereof.

While the inventive concepts have been particularly shown and described with reference to some example embodiments thereof, it will be understood that various changes in form and details may be made therein without departing from the scope of the following claims.

Further Embodiments are set out in the following Numbered Paragraphs (NPs):
NP1. A nonvolatile memory device comprising:
   a peripheral circuit structure comprising a peripheral circuit and a first insulating structure covering the peripheral circuit; and
   a cell array structure bonded to the peripheral circuit structure and comprising a cell region and a connection region, the cell array structure including
      a common source line layer;
      a buffer insulating layer on the common source line layer;
      a plurality of contact stop layers separated from the common source line layer and buried in the buffer insulating layer;
      a cell stack including a plurality of gate electrodes and a plurality of insulating layers alternately stacked on the buffer insulating layer, and in which the plurality of gate electrodes have a staircase shape in the connection region;
      a plurality of cell channel structures extending to the common source line layer by passing through the cell stack and the buffer insulating layer in the cell region;
      a plurality of contact structures respectively in contact with the plurality of contact stop layers by passing through the cell stack in the connection region, and each connected to one or more of the plurality of gate electrodes; and
      a second insulating structure in contact with the first insulating structure covering the cell stack.
NP2. The nonvolatile memory device of NP1, wherein the plurality of contact structures and the plurality of contact stop layers in contact with each other are formed together and integrated.
NP3. The nonvolatile memory device of NP1, wherein each of the plurality of contact structures comprises:
   a base contact portion; and
   a pad connection portion protruding in a horizontal direction from the base contact portion toward a connected gate electrode among the plurality of gate electrodes to be in contact with the connected gate electrode among the plurality of gate electrodes.
NP4. The nonvolatile memory device of NP3, wherein each of the plurality of gate electrodes comprises a pad portion in contact with the pad connection portion of each of the plurality of contact structures in the connection region, and a thickness of the pad portion is greater than a thickness of a portion of each of the plurality of gate electrodes in the cell region.
NP5. The nonvolatile memory device of NP4, wherein a thickness of the pad connection portion is a same as the thickness of the pad portion.
NP6. The nonvolatile memory device of NP3, wherein a horizontal width of each of the plurality of contact stop layers is greater than or equal to a horizontal diameter of the base contact portion of each of the plurality of contact structures.
NP7. The nonvolatile memory device of NP4, wherein each of the plurality of contact structures further comprises a protrusion portion protruding in the horizontal direction from the base contact portion toward a non-connected gate electrode among the plurality of gate electrodes, and a protruding length of the pad connection portion from the base contact portion is greater than a protruding length of the protrusion portion.
NP8. The nonvolatile memory device of NP7, further comprising an insulating spacer between the protrusion portion of each of the plurality of contact structures and the non-connected gate electrode among the plurality of gate electrodes.
NP9. The nonvolatile memory device of NP7, wherein, in the cell region, a thickness of each of the plurality of gate electrodes and the plurality of insulating layers is less than a height of the plurality of contact stop layers.
NP10. A nonvolatile memory device comprising:
   a peripheral circuit structure comprising
      a substrate,a peripheral circuit on the substrate,
      a first interconnect structure electrically connected to the peripheral circuit,
      a plurality of first bonding pads electrically connected to the first interconnect structure, and
      a first insulating structure surrounding the peripheral circuit, the first interconnect structure, and the plurality of first bonding pads on the substrate; and a second structure comprising
      a common source line layer,
      a buffer insulating layer on the common source line layer,
      a base insulating layer on the buffer insulating layer,
      a cell stack which comprises a plurality of gate electrodes and a plurality of insulating layers alternately stacked on the buffer insulating layer, and in which the plurality of gate electrodes have a staircase shape in a connection region,
      a plurality of cell channel structures extending to the common source line layer by passing through the cell stack, the base insulating layer, and the buffer insulating layer in a cell region,
      a plurality of contact structures passing through the cell stack and the base insulating layer in the connection region, and each connected to one or more of the plurality of gate electrodes and comprising a contact stop portion separated from the common source line layer and buried in the buffer insulating layer,
      a second interconnect structure electrically connected to the plurality of cell channel structures and the plurality of contact structures,
      a plurality of second bonding pads electrically connected to the second interconnect structure, and
      a second insulating structure surrounding the cell stack, the second interconnect structure, and the plurality of second bonding pads on the common source line layer, the second insulating structure being in contact with the first insulating structure, the plurality of second bonding pads bonded to the peripheral circuit structure to correspond to the plurality of first bonding pads, and the cell region and the connection region are included.
NP11. The nonvolatile memory device of NP10, wherein an upper surface of the contact stop portion is at a lower vertical level than an upper surface of the buffer insulating layer, and a lower surface of the contact stop portion is at a same vertical level as a lower surface of the buffer insulating layer.
NP12. The nonvolatile memory device of NP10, wherein each of the plurality of contact structures comprises:
   a base contact portion passing through the cell stack and the base insulating layer;
   the contact stop portion connected to the base contact portion; and
   a pad connection portion protruding in a horizontal direction from the base contact portion toward a connected gate electrode among the plurality of gate electrodes to be in contact with the connected gate electrode among the plurality of gate electrodes.
NP13. The nonvolatile memory device of NP12, wherein a horizontal width of the contact stop portion is greater than a horizontal diameter of the base contact portion.
NP14. The nonvolatile memory device of NP12, wherein each of the plurality of gate electrodes comprises a pad portion in contact with the pad connection portion of each of the plurality of contact structures in the connection region, and a thickness of the pad portion is greater than a thickness of a portion of each of the plurality of gate electrodes in the cell region and is the same as a thickness of the pad connection portion.
NP15. The nonvolatile memory device of NP12, further comprising a plurality of insulating spacers,
   wherein each of the plurality of contact structures further comprises a protrusion portion protruding in the horizontal direction from the base contact portion toward a non-connected gate electrode among the plurality of gate electrodes, and each of the plurality of insulating spacers is between the protrusion portion of each of the plurality of contact structures and the non-connected gate electrode among the plurality of gate electrodes.

## Claims

1. A nonvolatile memory device comprising:
a peripheral circuit structure comprising a peripheral circuit and a first insulating structure covering the peripheral circuit; and
a cell array structure bonded to the peripheral circuit structure and comprising a cell region and a connection region, the cell array structure including
a common source line layer;
a buffer insulating layer on the common source line layer;
a plurality of contact stop layers separated from the common source line layer and buried in the buffer insulating layer;
a cell stack including a plurality of gate electrodes and a plurality of insulating layers alternately stacked on the buffer insulating layer, and in which the plurality of gate electrodes have a staircase shape in the connection region;
a plurality of cell channel structures extending to the common source line layer by passing through the cell stack and the buffer insulating layer in the cell region;
a plurality of contact structures respectively in contact with the plurality of contact stop layers by passing through the cell stack in the connection region, and each connected to one or more of the plurality of gate electrodes; and
a second insulating structure in contact with the first insulating structure covering the cell stack.

2. The nonvolatile memory device of claim 1, wherein the plurality of contact structures and the plurality of contact stop layers in contact with each other are formed together and integrated.

3. The nonvolatile memory device of claim 1 or claim 2, wherein each of the plurality of contact structures comprises:
a base contact portion; and
a pad connection portion protruding in a horizontal direction from the base contact portion toward a connected gate electrode among the plurality of gate electrodes to be in contact with the connected gate electrode among the plurality of gate electrodes.

4. The nonvolatile memory device of claim 3, wherein each of the plurality of gate electrodes comprises a pad portion in contact with the pad connection portion of each of the plurality of contact structures in the connection region, and a thickness of the pad portion is greater than a thickness of a portion of each of the plurality of gate electrodes in the cell region.

5. The nonvolatile memory device of claim 4, wherein a thickness of the pad connection portion is a same as the thickness of the pad portion.

6. The nonvolatile memory device of any one of claims 3-5, wherein a horizontal width of each of the plurality of contact stop layers is greater than or equal to a horizontal diameter of the base contact portion of each of the plurality of contact structures.

7. The nonvolatile memory device of any one of claims 3-6, wherein each of the plurality of contact structures further comprises a protrusion portion protruding in the horizontal direction from the base contact portion toward a non-connected gate electrode among the plurality of gate electrodes, and a protruding length of the pad connection portion from the base contact portion is greater than a protruding length of the protrusion portion.

8. The nonvolatile memory device of claim 7, further comprising an insulating spacer between the protrusion portion of each of the plurality of contact structures and the non-connected gate electrode among the plurality of gate electrodes.

9. The nonvolatile memory device of claim 7 or claim 8, wherein, in the cell region, a thickness of each of the plurality of gate electrodes and the plurality of insulating layers is less than a height of the plurality of contact stop layers.

10. A nonvolatile memory device according to claim 1,
the peripheral circuit structure further comprising:
a substrate, wherein the peripheral circuit is on the substrate,
a first interconnect structure electrically connected to the peripheral circuit,
a plurality of first bonding pads electrically connected to the first interconnect structure, and
wherein the first insulating structure surrounds the peripheral circuit, the first interconnect structure, and the plurality of first bonding pads on the substrate;
wherein the cell array structure further comprises:
a base insulating layer on the buffer insulating layer,
wherein the plurality of gate electrodes and the plurality of insulating layers are alternately stacked on the buffer insulating layer, wherein the plurality of cell channel structures extend to the common source line layer by passing through the base insulating layer, and
wherein the plurality of contact structures pass through the base insulating layer in the connection region, and each of the plurality of contact structures comprises a contact stop layer of the plurality of contact stop layers,
a second interconnect structure electrically connected to the plurality of cell channel structures and the plurality of contact structures,
a plurality of second bonding pads electrically connected to the second interconnect structure, and
a second insulating structure surrounding the cell stack, the second interconnect structure, and the plurality of second bonding pads on the common source line layer, the second insulating structure being in contact with the first insulating structure, the plurality of second bonding pads bonded to the peripheral circuit structure to correspond to the plurality of first bonding pads, and the cell region and the connection region are included.

11. The nonvolatile memory device of claim 10, wherein an upper surface of the contact stop layer is at a lower vertical level than an upper surface of the buffer insulating layer, and a lower surface of the contact stop layer is at a same vertical level as a lower surface of the buffer insulating layer.

12. The nonvolatile memory device of claim 10 or claim 11, wherein each of the plurality of contact structures comprises:
a base contact portion passing through the cell stack and the base insulating layer;
the contact stop layer connected to the base contact portion; and
a pad connection portion protruding in a horizontal direction from the base contact portion toward a connected gate electrode among the plurality of gate electrodes to be in contact with the connected gate electrode among the plurality of gate electrodes.

13. The nonvolatile memory device of claim 12, wherein a horizontal width of the contact stop layer is greater than a horizontal diameter of the base contact portion.

14. The nonvolatile memory device of claim 12 or claim 13, wherein each of the plurality of gate electrodes comprises a pad portion in contact with the pad connection portion of each of the plurality of contact structures in the connection region, and a thickness of the pad portion is greater than a thickness of a portion of each of the plurality of gate electrodes in the cell region and is the same as a thickness of the pad connection portion.

15. The nonvolatile memory device of any one of claims 12 - 14, further comprising a plurality of insulating spacers,
wherein each of the plurality of contact structures further comprises a protrusion portion protruding in the horizontal direction from the base contact portion toward a non-connected gate electrode among the plurality of gate electrodes, and each of the plurality of insulating spacers is between the protrusion portion of each of the plurality of contact structures and the non-connected gate electrode among the plurality of gate electrodes.
